# EUROPEAN PATENT APPLICATION

(11) **EP 4 694 645 A2**
(43) Date of publication of application: **11.02.2026**
(21) Application number: 25189113.1
(22) Date of filing: 11.07.2025
(51) Int. Cl.: H10K 59/123, H10K 59/131, H10K 59/80

(54) **DISPLAY DEVICE AND ELECTRONIC DEVICE**

(30) Priority: 15.07.2024 KR 20240092948
(71) Applicant: Samsung Display Co., Ltd., Yongin-si, Gyeonggi-do 17113 (KR)
(72) Inventor: LEE, Pilsuk, 17113 Yongin-si (KR); HONG, Sungjin, 17113 Yongin-si (KR)
(74) Representative: Taor, Simon Edward William

(57) **Abstract**

Provided is a display device including a base layer including a display area in which multiple pixels are disposed, and a non-display area disposed around the display area, a conductive layer overlapping a least a portion of multiple pixels in a plan view, a first power line electrically connected to multiple pixels, and a second power line electrically connected to multiple pixels. The conductive layer includes a first conductive layer overlapping a first pixel of multiple pixels in a plan view, and a second conductive layer overlapping a second pixel of multiple pixels in a plan view and disposed apart from the first conductive layer. The first power line includes a (1-1)-th power line electrically connected to the first pixel through the first conductive layer, and a (1-2)-th power line electrically connected to the second pixel through the second conductive layer.

## Description

### CROSS-REFERENCE TO RELATED APPLICATION(S)

This application claims priority to and benefits of Korean Patent Application No. 10-2024-0092948 filed on July 15, 2024.

### BACKGROUND

### 1. Technical Field

The disclosure relates to a display device, and more particularly, to a display device having a display area with improved display quality.

### 2. Description of the Related Art

In general, electronic devices such as smartphones, digital cameras, notebook computers, navigation devices and smart televisions, which provide images for users, include display devices for displaying the images. The display devices generate images and provide users with the generated images through display screens.

A display device includes a plurality of pixels for generating an image, a scan driving circuit which applies scan signals to the pixels, a data driver which applies data voltages to the pixels, and an emission driver which applies emission signals to the pixels. The pixels receive the data voltages in response to the scan signals. The pixels display an image by emitting light having luminance levels corresponding to the data voltages in response to the emission signals.

The pixels may display a dynamic image and a still image. When the pixels display the dynamic image, the pixels may be provided with continuously updated images. When the pixels display the still image, the pixels may maintain the initially provided image and subsequently not be provided with an image.

### SUMMARY

The disclosure provides a display device capable of improving display quality as pixels output light at different luminance levels from each other.

An embodiment of the disclosure provides a display device including a base layer including a display area in which a plurality of pixels are disposed, and a non-display area disposed around the display area, a conductive layer overlapping a least a portion of the plurality of pixels in a plan view, a first power line electrically connected to the plurality of pixels, and a second power line electrically connected to the plurality of pixels. The conductive layer includes a first conductive layer overlapping a first pixel of the plurality of pixels in a plan view, and a second conductive layer overlapping a second pixel of the plurality of pixels in a plan view and disposed apart from the first conductive layer. The first power line may include a (1-1)-th power line electrically connected to the first pixel through the first conductive layer, and a (1-2)-th power line electrically connected to the second pixel through the second conductive layer.

In an embodiment, each of the plurality of pixels may include a pixel driver disposed on the base layer, and including a transistor, and a light emitting element disposed on the transistor and including a first electrode, an intermediate layer disposed on the first electrode, and a second electrode disposed on the intermediate layer. The first power line may be electrically connected to the first electrode, and the second power line may be electrically connected to the transistor.

In an embodiment, the first electrode may include a (1-1)-th electrode electrically connected to the (1-1)-th power line, and a (1-2)-th electrode electrically connected to the (1-2)-th power line, and the (1-1)-th electrode and the (1-2)-th electrode may be electrically disconnected from each other.

In an embodiment, the (1-1)-th electrode and the first conductive layer may be disposed on different layers, and the (1-1)-th electrode may be electrically connected to the first conductive layer through a first contact hole, and the (1-2)-th electrode and the second conductive layer may be disposed on different layers, and the (1-2)-th electrode may be electrically connected to the second conductive layer through a second contact hole.

In an embodiment, the (1-1)-th electrode may include a plurality of first sub-electrodes, and the first sub-electrodes may be disposed apart from each other in a plan view.

In an embodiment, the first conductive layer may overlap a portion of each of the first sub-electrodes in a plan view.

In an embodiment, the first conductive layer may include a plurality of first sub-conductive layers, and the first sub-conductive layers may have shapes corresponding to shapes of the first sub-electrodes, respectively.

In an embodiment, the first conductive layer may further include a connection pattern which connects the first sub-conductive layers together.

In an embodiment, the (1-1)-th power line may include a horizontal line extending in a first direction, and a vertical line extending in a second direction intersecting the first direction, and the horizontal line may be disposed on the same layer as the first conductive layer and extend from the first conductive layer.

In an embodiment, the vertical line may extend from the horizontal line and not overlap the first electrode in a plan view.

In an embodiment, the vertical line and the horizontal line may be disposed on different layers, and electrically connected to the horizontal line through a contact hole.

In an embodiment, a surface area of the first conductive layer may be greater than a surface area of the (1-1)-th electrode, and a surface area of the second conductive layer may be greater than a surface area of the (1-2)-th electrode.

In an embodiment, a planar shape of the first conductive layer and a planar shape of the second conductive layer may be different.

In an embodiment, the (1-1)-th power line may apply a first voltage to the first pixel, and the (1-2)-th power line may apply, to the second pixel, a second voltage different from the first voltage.

In an embodiment, the (1-1)-th power line and the first conductive layer may be disposed on different layers, and the (1-1)-th power line may be electrically connected to the first conductive layer through a contact hole.

In an embodiment, the (1-1)-th power line may overlap the pixels.

In an embodiment, the display device according to an embodiment of the disclosure may further include a pad portion disposed in the non-display area, and the pad portion may include a first pad electrically connected to the first power line, and a second pad electrically connected to the second power line.

In an embodiment, the first pad may include a (1-1)-th pad electrically connected to the (1-1)-th power line, and a (1-2)-th pad electrically connected to the (1-2)-th power line.

In an embodiment, the pad portion may include a first pad portion and a second pad portion which are spaced apart from each other with respect to the display area therebetween.

In an embodiment, the first pixel may include a plurality of first sub-pixels, and the first sub-pixels may overlap the first conductive layer in a plan view.

In an embodiment, each of the plurality of pixels may include a pixel driver disposed on the base layer and including a transistor, and a light emitting element disposed on the transistor and including a first electrode, an intermediate layer disposed on the first electrode, and a second electrode disposed on the intermediate layer, and the display device according to an embodiment of the disclosure may further include a connection electrode which electrically connects the transistor and the second electrode together.

In an embodiment, the display device according to an embodiment of the disclosure may further include a pixel defining film in which an opening which exposes at least a portion of the first electrode is defined, and a separator disposed on the pixel defining film. In a contact area adjacent to the separator, a bottom surface of the second electrode may be in contact with a top surface of the connection electrode.

In an embodiment, the connection electrode may have a ring shape which surrounds the opening.

In an embodiment of the disclosure, a display device includes a base layer including a display area divided into a plurality of areas, and a non-display area disposed around the display area, a circuit element layer disposed on the base layer and including a pixel driver, a plurality of light emitting elements disposed on the circuit element layerand each including a first electrode, an intermediate layer disposed on the first electrode, and a second electrode disposed on the intermediate layer, a first power line electrically connected to the first electrode included in each of the light emitting elements, and a second power line electrically connected to a transistor included in the pixel driver. The first electrode may include a (1-1)-th electrode, which is disposed in a first area of the plurality of areas and receives a first voltage through a (1-1)-th power line of the first power line, and a (1-2)-th electrode which is disposed in a second area of the plurality of areas and receives a second voltage different from the first voltage through a (1-2)-th power line of the first power line.

In an embodiment, the (1-1)-th electrode may include a plurality of first sub-electrodes, and a connection pattern which electrically connects the first sub-electrodes together.

In an embodiment, the (1-1)-th power line and the first sub-electrodes may be disposed on different layers, and the (1-1)-th power line may be electrically connected to the first sub-electrodes through contact holes.

In an embodiment, the display device according to an embodiment of the disclosure may further include a first conductive layer overlapping the (1-1)-th electrode, the first conductive layer and the (1-1)-th electrode disposed on different layers, and a second conductive layer overlapping the (1-2)-th electrode, the second conductive layer and the (1-2)-th electrode disposed on different layers.

In an embodiment, the (1-1)-th electrode may be electrically connected to the first conductive layer through a first contact hole, and the (1-2)-th electrode may be electrically connected to the second conductive layer through a second contact hole.

In an embodiment, the (1-1)-th power line may include a horizontal line extending in a first direction, and a vertical line extending in a second direction intersecting the first direction, and the horizontal line and the first conductive layer may be disposed on the same layer, and the horizontal line may extend from the first conductive layer.

In an embodiment, the vertical line may extend from the horizontal line and not overlap the (1-1)-th electrode in a plan view.

In an embodiment, the vertical line and the horizontal line may be disposed on different layers, and the vertical line may be electrically connected to the horizontal line through a contact hole.

In an embodiment, the (1-1)-th power line and the first conductive layer may be disposed on different layers, and the (1-1)-th power line may be electrically connected to the first conductive layer through a contact hole.

In an embodiment of the disclosure, an electronic device includes a display device, an electronic module overlapping the display device and a housing accommodating the display device. The display device includes a base layer including a display area in which a plurality of pixels are disposed, and a non-display area disposed around the display area, a conductive layer overlapping a least a portion of the plurality of pixels in a plan view, a first power line electrically connected to the plurality of pixels, and a second power line electrically connected to the plurality of pixels. The conductive layer includes a first conductive layer overlapping a first pixel of the plurality of pixels in a plan view, and a second conductive layer overlapping a second pixel of the plurality of pixels in a plan view and disposed apart from the first conductive layer. The first power line may include a (1-1)-th power line electrically connected to the first pixel through the first conductive layer, and a (1-2)-th power line electrically connected to the second pixel through the second conductive layer.

In an embodiment, the electronic device may be at least one of a smart watch, a mobile phone, a smartphone, a portable computer, a tablet personal computer (PC), a watch phone, an automotive display, a smart glass, a portable multimedia player (PMP), a navigation system, an ultra-mobile computer (UMPC), a head mounted display (HMD) device, a virtual reality (VR) device, a mixed reality (MR) device, and an augmented reality (AR) device.

According to an aspect, there is provided a display device as set out in claim 1. Additional features are set out in claims 2 to 13. According to an aspect, there is provided a display device as set out in claim 14. According to an aspect, there is provided an electronic device as set out in claim 1.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain principles of the disclosure. In the drawings:
FIG. 1 is a schematic perspective view of an electronic device according to an embodiment of the disclosure;
FIG. 2A is a schematic cross-sectional view of a display device included in the electronic device in FIG. 1;
FIG. 2B is a schematic cross-sectional view of a display panel illustrated in FIG. 2A;
FIG. 3 is a schematic block diagram of a display device according to an embodiment of the disclosure;
FIGS. 4A, 4B, and 4C are each a schematic diagram of an equivalent circuit of a pixel according to an embodiment of the disclosure;
FIGS. 5A and 5B are each a schematic plan view illustrating a display panel according to an embodiment of the disclosure;
FIG. 6 is a schematic plan view of a display panel and a driving circuit part according to an embodiment of the disclosure;
FIGS. 7A to 7D are each an enlarged schematic plan view of a partial area of a display panel according to an embodiment of the disclosure;
FIG. 8 is a schematic cross-sectional view of a display module according to an embodiment of the disclosure;
FIGS. 9A and 9B are each an enlarged schematic cross-sectional view illustrating a partial area of a display panel according to an embodiment of the disclosure;
FIG. 10 is an enlarged schematic view of area CC' illustrated in FIG. 7D;
FIG. 11A is a schematic cross-sectional view of a display panel corresponding to line II-II' illustrated in FIG. 10 according to an embodiment of the disclosure;
FIGS. 11B to 11D are each a schematic cross-sectional view of a display panel corresponding to line II-II' illustrated in FIG. 10 according to an embodiment of the disclosure;
FIGS. 12A to 12E are each an enlarged schematic plan view of a partial area of a display panel according to an embodiment of the disclosure; and
FIGS. 13 and 14 are each a schematic plan view of a display panel and a driving circuit part according to an embodiment of the disclosure.
FIG. 15 is a schematic perspective view of an electronic device according to an embodiment of the disclosure.
FIG. 16 is a schematic view illustrating a folded state of the electronic device illustrated in FIG. 15.
FIG. 17 is an exploded schematic perspective view of the electronic device illustrated in FIG. 15.
FIG. 18 is a schematic block diagram of the electronic device illustrated in FIG. 15.
FIG. 19 is a schematic view showing an example of a smart watch including a display device according to an embodiment of the disclosure.

### DETAILED DESCRIPTION OF THE EMBODIMENTS

The disclosure may be modified in various forms, and particular embodiments thereof will be illustrated in the drawings and described herein in detail. The disclosure should not be construed as limited to the embodiments set forth herein. Rather, these embodiments are provided so that this disclosure will be thorough and complete, and will fully convey the scope of the disclosure to those skilled in the art.

In this specification, it will be understood that when an element (or region, layer, section, etc.) is referred to as being "on", "connected to" or "coupled to" another element, it can be disposed directly on, connected or coupled to the other element or a third element may be disposed between the elements.

Like reference numbers or symbols refer to like elements throughout. In addition, in the drawings, the thickness, the ratio, and the dimension of elements are exaggerated for effective description of the technical contents.

The term "and/or" includes one or more combinations which may be defined by relevant elements.

It will be understood that, although the terms first, second, etc. may be used herein to describe various elements, these elements should not be limited by these terms. These terms are only used to distinguish one element from another element. For example, a first element could be termed a second element without departing from the teachings of the disclosure, and similarly, a second element could be termed a first element. As used herein, the singular forms are intended to include the plural forms as well, unless the context clearly indicates otherwise.

The terms, such as "below", "beneath", "on" and "above", are used for explaining the relation of elements shown in the drawings. The terms are relative concept and are explained based on the direction shown in the drawing.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that the terms such as "includes" or "has", when used herein, specify the presence of stated features, numerals, steps, operations, elements, parts, or the combination thereof, but do not preclude the presence or addition of one or more other features, numerals, steps, operations, elements, parts, or the combination thereof.

Hereinafter, embodiments of the disclosure will be described with reference to the accompanying drawings.

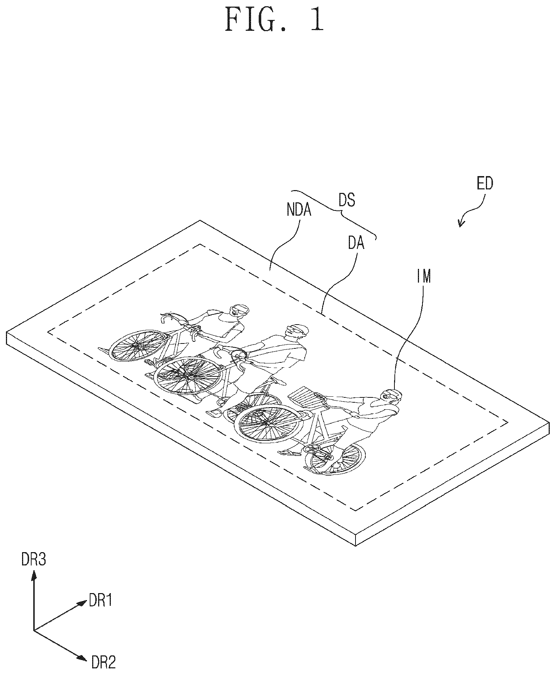

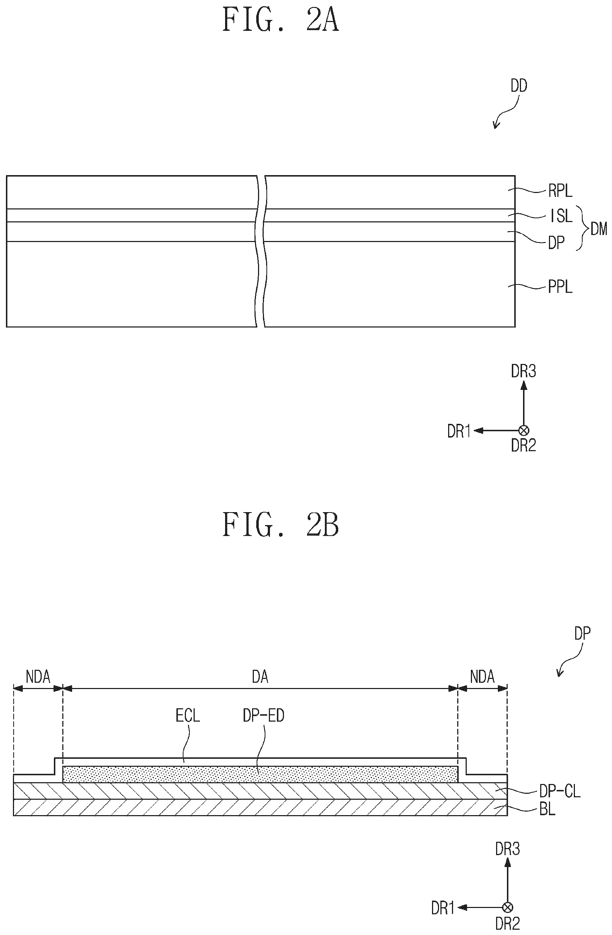

FIG. 1 is a schematic perspective view of an electronic device according to an embodiment of the disclosure. FIG. 2A is a schematic cross-sectional view of a display device included in the electronic device in FIG. 1. FIG. 2B is a schematic cross-sectional view of a display panel illustrated in FIG. 2A.

Referring to FIG. 1, an electronic device ED according to an embodiment of the disclosure may have a rectangular shape having short sides extending in a first direction DR1 and long sides extending in a second direction DR2 intersecting the first direction DR1. However, embodiments of the disclosure are not limited thereto, and the electronic device ED may have various shapes such as a circular shape and a polygonal shape.

Hereinafter, a direction substantially perpendicularly intersecting a plane defined by the first direction DR1 and the second direction DR2 is defined as a third direction DR3. The state "when viewed on a plane" used herein may be defined as a state when viewed in the third direction DR3 (e.g., in a plan view).

A top surface of the electronic device ED may be defined as a display surface DS, and the display surface DS may have a plane defined by the first direction DR1 and the second direction DR2. Images IM generated in the electronic device ED may be provided for users through the display surface DS.

The display surface DS may include a display area DA and a non-display area NDA around the display area DA. The display area DA may display an image, and the non-display area NDA may not display an image. The non-display area NDA may surround the display area DA and define an edge of the electronic device ED, which is printed to have a predetermined color.

Although not illustrated, the electronic device ED may include a display device DD (see FIG. 2A). The display device DD will be described below in detail.

Referring to FIG. 2A, the display device DD may include a display module DM, an anti-reflective layer RPL disposed on the display module DM, and a panel protective layer PPL disposed below the display module DM. The display module DM may include a display panel DP and a sensing layer ISL disposed on the display panel DP. The display panel DP may be a flexible panel. For example, the display panel DP may include a flexible substrate and multiple elements disposed on the flexible substrate.

The display panel DP according to an embodiment of the disclosure may be an emissive display panel, and is not particularly limited. For example, the display panel DP may be an organic light emitting display panel or an inorganic light emitting display panel. An emission layer of the organic light emitting display panel may include an organic light emitting material. An emission layer of the inorganic light emitting display panel may include a quantum dot, a quantum rod, and the like. Hereinafter, the display panel DP is described as the organic light emitting display panel.

The sensing layer ISL may include multiple sensers (not illustrated) for sensing an external input by using a capacitance method. The sensing layer ISL may be formed (e.g., directly formed) on the display panel DP without a separate adhesive layer during manufacture of the display device DD.

The anti-reflective layer RPL may be disposed on the sensing layer ISL. The anti-reflective layer RPL may be formed (e.g., directly formed) on the sensing layer ISL during the manufacture of the display device DD. The anti-reflective layer RPL may be defined as a film that prevents the reflection of external light. The anti-reflective layer RPL may reduce the reflectance of external light incident from above the electronic device ED toward the display panel DP.

As an example, the sensing layer ISL may be disposed (e.g., directly disposed) on the display panel DP, and the anti-reflective layer RPL may be disposed (e.g., directly disposed) on the sensing layer ISL. However, embodiments of the disclosure are not limited thereto. For example, the sensing layer ISL may be separately manufactured to be attached to the display panel DP through an adhesive layer, and the anti-reflective layer RPL may be separately manufactured to be attached to the sensing layer ISL through an adhesive layer.

The panel protective layer PPL may be disposed below the display panel DP. The panel protective layer PPL may protect a lower portion of the display panel DP. The panel protective layer PPL may include a flexible plastic material. For example, the panel protective layer PPL may include a polyethylene terephthalate (PET).

Referring to FIG. 2B, the display panel DP may include a base layer BL, a circuit element layer DP-CL disposed on the base layer BL, a display element layer DP-ED disposed on the circuit element layer DP-CL, and an encapsulation layer ECL disposed on the display element layer DP-ED.

The base layer BL may include a display area DA and a non-display area NDA around the display area DA. The base layer BL may include glass, or a flexible plastic material such as polyimide (PI). The display element layer DP-ED may be disposed on the display area DA.

Multiple pixels may be disposed in the circuit element layer DP-CL and the display element layer DP-ED. Each of the pixels may include a transistor disposed in the circuit element layer DP-CL, and a light emitting element disposed in the display element layer DP-ED and connected to the transistor.

The encapsulation layer ECL may be disposed on the circuit element layer DP-CL so as to cover the display element layer DP-ED. The encapsulation layer ECL may protect the pixels from moisture, oxygen, and external foreign substances.

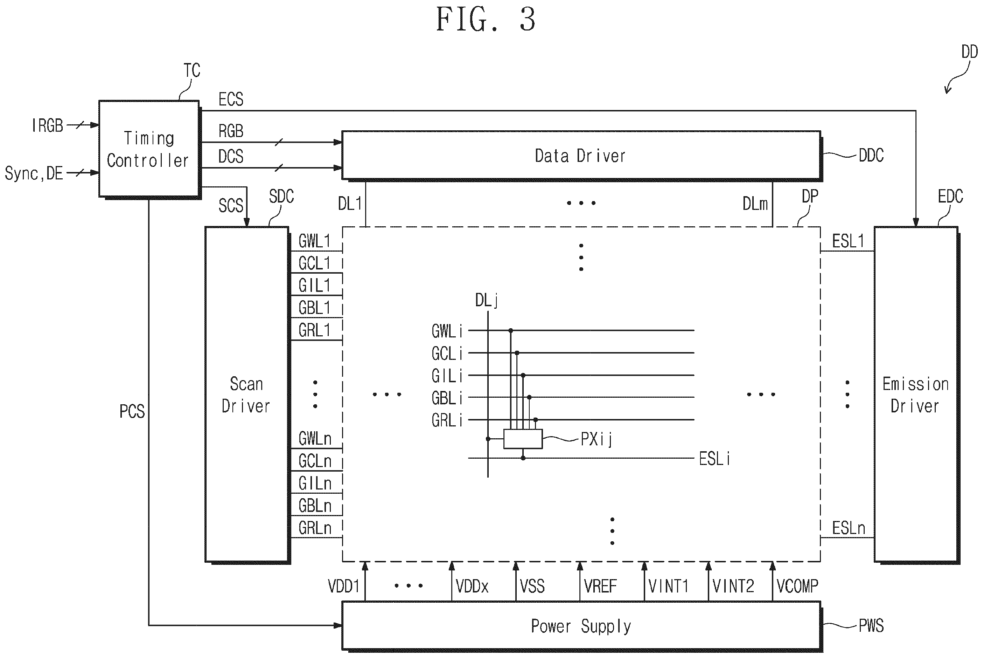

FIG. 3 is a schematic block diagram of a display device according to an embodiment of the disclosure.

Referring to FIG. 3, a display device DD may include a display panel DP, panel drivers SDC, EDC and DDC, a power supply PWS, and a timing controller TC. The panel drivers SDC, EDC and DDC may include a scan driver SDC, an emission driver EDC, and a data driver DDC.

The display panel DP may include scan lines GWL1 to GWLn, GCL1 to GCLn, GIL1 to GILn, GBL1 to GBLn and GRL1 to GRLn, emission lines ESL1 to ESLn, and data lines DL1 to DLm. The display panel DP may include multiple pixels connected to the scan lines GWL1 to GWLn, GCL1 to GCLn, GIL1 to GILn, GBL1 to GBLn and GRL1 to GRLn, the emission lines ESL1 to ESLn, and the data lines DL1 to DLm (here, m and n are each an integer of 1 or more).

For example, a pixel PXij (here, i and j are each an integer of 1 or more) disposed on an i-th horizontal line (or i-th pixel row) and a j-th vertical line (or j-th pixel column) may be electrically connected to an i-th first scan line GWLi (or write scan line), an i-th second scan line GCLi (or compensation scan line), an i-th third scan line GILi (or first initialization scan line), an i-th fourth scan line GBLi (or second initialization scan line), an i-th fifth scan line GRLi (or reset scan line), a j-th data line DLj, and a i-th emission line ESLi.

The pixel PXij may include multiple light emitting elements, multiple transistors, and multiple capacitors. The pixel PXij may receive, through the power supply PWS, first power voltages VDD1 to VDDx, a second power voltage VSS, a third power voltage VREF (or reference voltage), a fourth power voltage VINT1 (or first initialization voltage), a fifth power voltage VINT2 (or second initialization voltage), and a sixth power voltage VCOMP (or compensation voltage). The first power voltages VDD1 to VDDx may include a first voltage VDD1 to an x-th voltage VDDx. This will be described later in detail.

Each of the first power voltages VDD1 to VDDx and the second power voltage VSS may have a voltage value that is set so that current flows through the light emitting element to emit light. For example, each of the first power voltages VDD1 to VDDx may be set to a voltage higher than the second power voltage VSS.

The third power voltage VREF may be a voltage for initializing a gate of a driving transistor included in the pixel PXij. The third power voltage VREF may be used to realize a predetermined grayscale by using a voltage difference with a data signal. For this, the third power voltage VREF may be set to a predetermined voltage within the voltage range of the data signal.

The fourth power voltage VINT1 may be a voltage for initializing the capacitor included in the pixel PXij. The fourth power voltage VINT1 may be set to a voltage lower than the third power voltage VREF. For example, the fourth power voltage VINT1 may be set to a voltage lower than a difference between the third power voltage VREF and a threshold voltage of the driving transistor. However, embodiments of the disclosure are not limited thereto.

The fifth power voltage VINT2 may be a voltage for initializing a cathode (or a second electrode) of the light emitting element included in the pixel PXij. The fifth power voltage VINT2 may be set to a voltage lower than the first power voltages VDD1 to VDDx or the fourth power voltage VINT1, or set to a voltage similar to or the same as the third power voltage VREF. However, embodiments of the disclosure are not limited thereto, and the fifth power voltage VINT2 may be set to a voltage similar to or the same as the first power voltages VDD1 to VDDx.

The sixth power voltage VCOMP may supply a predetermined current to the driving transistor during compensation of the threshold voltage of the driving transistor.

FIG. 3 illustrates an embodiment in which all of the first to sixth power voltages VDD1 to VDDx, VSS, VREF, VINT1, VINT2 and VCOMP are supplied from the power supply PWS, but embodiments of the disclosure are not limited thereto. For example, the first power voltages VDD1 to VDDx and the second power voltage VSS may be all supplied irrespective of a structure of the pixel PXij, and at least one of the third power voltage VREF, the fourth power voltage VINT1, the fifth power voltage VINT2, or the sixth power voltage VCOMP may not be supplied corresponding to the structure of the pixel PXij.

The signal lines connected to the pixel PXij may be variously set to corresponding to a circuit structure of the pixel PXij.

The scan driver SDC may receive a first control signal SCS from the timing controller TC and supply a scan signal to each of first scan lines GWL1 to GWLn, second scan lines GCL1 to GCLn, third scan lines GIL1 to GILn, fourth scan lines GBL1 to GBLn, and fifth scan lines GRL1 to GRLn, based on the first control signal SCS.

The scan signal may be set to a voltage to turn on transistors supplied with the scan signal. For example, the scan signal supplied to a p-type transistor may be set to a logic low level, and the scan signal supplied to an n-type transistor may be set to a logic high level. Hereinafter, in case that the "scan signal is supplied", it may be understood that the scan signal is supplied at a logic level to turn on the transistor controlled by the scan signal.

For concise explanation, FIG. 3 illustrates the scan driver SDC as a single component, but embodiments of the disclosure are not limited thereto. According to an embodiment, multiple scan drivers may be included so as to supply scan signals to the first scan lines GWL1 to GWLn, the second scan lines GCL1 to GCLn, the third scan lines GIL1 to GILn, the fourth scan lines GBL1 to GBLn, and the fifth scan lines GRL1 to GRLn, respectively.

The emission driver EDC may supply emission signals to the emission lines ESL1 to ESLn based on a second control signal ECS. For example, the emission signals may be sequentially supplied to the emission lines ESL1 to ESLn.

The transistors electrically connected to the emission lines ESL1 to ESLn according to an embodiment of the disclosure may be provided as n-type transistors. Here, the emission signal supplied to the emission lines ESL1 to ESLn may be set to a gate-off voltage. The transistors which receive the emission signals may be turned off in case that the emission signal is supplied, and be set to a turn-on state in the other cases.

The second control signal ECS may include an emission start signal and clock signals, and the emission driver EDC may be implemented as a shift register which sequentially shifts the emission start signal in the pulse form by using the clock signals to sequentially generate and output the emission signal in a pulse form.

The data driver DDC may receive a third control signal DCS and image data RGB from the timing controller TC. The data driver DDC may convert the image data RGB in a digital form into an analog data signal (i.e., a data signal). The data driver DDC may supply a data signal to the data lines DL1 to DLm in response to the third control signal DCS.

The third control signal DCS may include a data enable signal which instructs output of a valid data signal, a horizontal start signal, a data clock signal, and the like. For example, the data driver DDC may include a shift register which generates a sampling signal by shifting a horizontal start signal in synchronization with the data clock signal, a latch which latches the image data RGB in response to the sampling signal, a digital-to-analog converter (or decoder) which converts the latched image data (e.g., data in a digital form) into data signals in an analog form, and buffers (or amplifiers) which output the data signals to the data lines DL1 to DLm.

The power supply PWS may supply, to the display panel DP, the first power voltages VDD1 to VDDx, the second power voltage VSS, and the third power voltage VREF for driving the pixel PXij. Also, the power supply PWS may supply, to the display panel DP, at least one of the fourth power voltage VINT1, the fifth power voltage VINT2, or the sixth power voltage VCOMP.

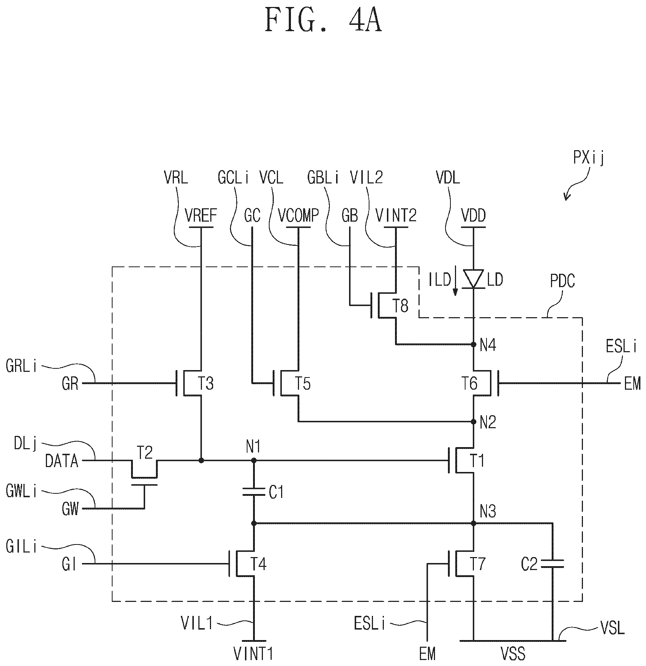

As one example, the power supply PWS may supply, to the display panel DP, the first power voltages VDD1 to VDDx, the second power voltage VSS, the third power voltage VREF, the fourth power voltage VINT1, the fifth power voltage VINT2, and the sixth power voltage VCOMP through a first power line VDL (see FIG. 4A), a second power line VSL (see FIG. 4A), a third power line VRL (or reference voltage line) (see FIG. 4A), a fourth power line VIL1 (or first initialization voltage line) (see FIG. 4A), a fifth power line VIL2 (or second initialization voltage line) (see FIG. 4A), and a sixth power line VCL (or compensation voltage line) (see FIG. 4A), respectively, which are not illustrated in this embodiment. The power supply PWS may be implemented as a power management integrated circuit (PMIC), but is not limited thereto.

The timing controller TC may generate the first control signal SCS, the second control signal ECS, the third control signal DCS, and a fourth control signal PCS, based on input image data IRGB, a synchronization signal Sync (e.g., a vertical synchronization signal, a horizontal synchronization signal, or the like), a data enable signal DE, the clock signal, and the like. The first control signal SCS may be supplied to the scan driver SDC, the second control signal ECS may be supplied to the emission driver EDC, the third control signal DCS may be supplied to the data driver DDC, and the fourth control signal PCS may be supplied to the power supply PWS. The timing controller TC may rearrange the input image data IRGB corresponding to the arrangement of the pixel PXij in the display panel DP and generate the image data RGB (or frame data).

The scan driver SDC, the emission driver EDC, the data driver DDC, the power supply PWS, and/or the timing controller TC may be directly provided in the display panel DP, or may be provided in the form of a separate driving chip and electrically connected to the display panel DP. In another embodiment, at least two of the scan driver SDC, the emission driver EDC, the data driver DDC, the power supply PWS, and the timing controller TC may be provided as one driving chip. For example, the data driver DDC and the timing controller TC may be provided as one driving chip.

The display device DD according to an embodiment is described with reference to FIG. 3, but the display device according to embodiments of the disclosure are not limited thereto. The signal lines may be further added or omitted according to the configuration of the pixel. Also, a connection relationship between one pixel and the signal lines may be changed. In a case in which one of the signal lines is omitted, the omitted signal line may be replaced with another signal line.

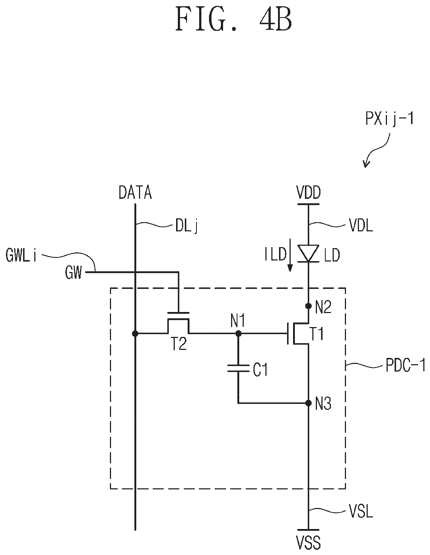

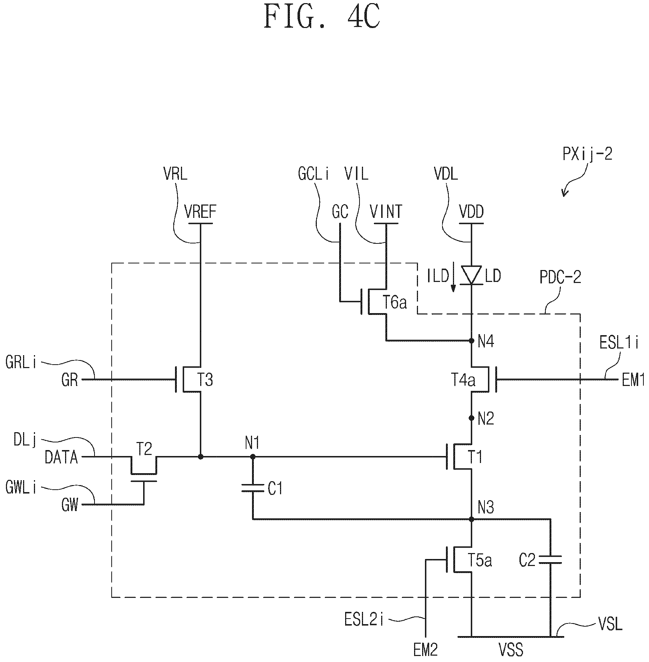

FIGS. 4A, 4B, and 4C are each a schematic diagram of an equivalent circuit of a pixel according to an embodiment of the disclosure. As an example, FIGS. 4A, 4B, and 4C illustrate respectively equivalent circuit diagrams of pixels PXij, PXij-1 and PXij-2, each of which is electrically connected to an i-th first scan line GWLi (hereinafter referred to as the first scan line) and electrically connected to a j-th data line DLj (hereinafter referred to as the data line).

As illustrated in FIG. 4A, the pixel PXij may include a light emitting element LD and a pixel driver PDC. The light emitting element LD may be electrically connected to a first power line VDL and the pixel driver PDC.

The pixel driver PDC may be electrically connected to multiple scan lines GWLi, GCLi, GILi, GBLi and GRLi, the data line DLj, an emission line ESLi, and multiple power voltage lines VDL, VSL, VIL1, VIL2, VRL and VCL. The pixel driver PDC may include first to eighth transistors T1, T2, T3, T4, T5, T6, T7 and T8, a first capacitor C1, and a second capacitor C2. Hereinafter, an embodiment will be described with an example in which each of the first to eighth transistors T1, T2, T3, T4, T5, T6, T7 and T8 is an n-type transistor. However, embodiments of the disclosure are not limited thereto, and some of the first to eighth transistors T1 to T8 may be n-type transistors and the remainder may be p-type transistors. In another embodiment, the first to eighth transistors T1 to T8 may each be a p-type transistor and are not limited thereto.

A gate of the first transistor T1 may be connected to a first node N1. A first electrode of the first transistor T1 may be connected to a second node N2, and a second electrode thereof may be connected to a third node N3. The first transistor T1 may be a driving transistor. The first transistor T1 may control a driving current ILD flowing from the first power line VDL to a second power line VSL via the light emitting element LD in response to a voltage of the first node N1. Here, a first power voltage VDD may be set to a voltage having a higher potential than a second power voltage VSS. Here, the first power voltage VDD may be one of the first voltage VDD1 to the x-th voltage VDDx described with reference to FIG. 3. The first power line VDL may be provided in plurality, and multiple first power lines VDL may supply one of the first voltage VDD1 to the x-th voltage VDDx to the light emitting element LD. The driving current ILD may vary depending on a voltage level of each of the first voltage VDD1 to the x-th voltage VDDx.

In the disclosure, in case that "a transistor and a signal line or a transistor and a transistor are electrically connected together", it means that "a source, a drain, and a gate of the transistor has a shape of one body together with the signal line or are connected through a connection electrode".

The second transistor T2 may include a gate connected to a write scan line GWLi, a first electrode connected to the data line DLj, and a second electrode connected to the first node N1. The second transistor T2 may supply a data signal DATA to the first node N1 in response to a write scan signal GW transmitted through the write scan line GWLi. In case that the write scan signal GW is supplied to the write scan line GWLi, the second transistor T2 may be turned on to electrically connect the data line DLj to the first node N1 together.

The third transistor T3 may be connected between the first node N1 and a reference voltage line VRL. A first electrode of the third transistor T3 may receive a reference voltage VREF through the reference voltage line VRL, and a second electrode of the third transistor T3 may be connected to the first node N1. A gate of the third transistor T3 may receive a reset scan signal GR through the i-th fifth scan line GRLi (hereinafter referred to as a reset scan line). In case that the reset scan signal GR is supplied to the reset scan line GRLi, the third transistor T3 may be turned on to supply the reference voltage VREF to the first node N1.

The fourth transistor T4 may be connected between the third node N3 and a first initialization voltage line VIL1. A first electrode of the fourth transistor T4 may be connected to the third node N3, and a second electrode of the fourth transistor T4 may be connected to the first initialization voltage line VIL1 that supplies a first initialization voltage VINT1. The fourth transistor T4 may be referred to as a first initialization transistor. A gate of the fourth transistor T4 may receive a first initialization scan signal GI through the i-th third scan line GILi (hereinafter referred to as a first initialization scan line). In case that the first initialization scan signal GI is supplied to the first initialization scan line GILi, the fourth transistor T4 may be turned on to supply the first initialization voltage VINT1 to the third node N3.

The fifth transistor T5 may be connected between a compensation voltage line VCL and the second node N2. A first electrode of the fifth transistor T5 may receive a compensation voltage VCOMP through the compensation voltage line VCL, and a second electrode of the fifth transistor T5 may be connected to the second node N2 and electrically connected to the first electrode of the first transistor T1. A gate of the fifth transistor T5 may receive a compensation scan signal GC through the i-th second scan line GCLi (hereinafter referred to as a compensation scan line). In case that the compensation scan signal GC is supplied to the compensation scan line GCLi, the fifth transistor T5 may be turned on to supply the compensation voltage VCOMP to the second node N2, and a threshold voltage of the first transistor T1 may be compensated for a compensation period.

The sixth transistor T6 may be connected between the first transistor T1 and the light emitting element LD. For example, a gate of the sixth transistor T6 may receive an emission signal EM through the i-th emission line ESLi (hereinafter referred to as the emission line). A first electrode of the sixth transistor T6 may be connected to a cathode of the light emitting element LD through a fourth node N4, and a second electrode of the sixth transistor T6 may be connected to the first electrode of the first transistor T1 through the second node N2. The sixth transistor T6 may be referred to as a first emission control transistor. In case that the emission signal EM is supplied to the emission line ESLi, the sixth transistor T6 may be turned on to electrically connect the light emitting element LD to the first transistor T1 together.

The seventh transistor T7 may be connected between the second power line VSL and the third node N3. A first electrode of the seventh transistor T7 may be connected to the second electrode of the first transistor T1 through the third node N3, and a second electrode of the seventh transistor T7 may receive the second power voltage VSS through the second power line VSL. A gate of the seventh transistor T7 may be electrically connected to the emission line ESLi. The seventh transistor T7 may be referred to as a second emission control transistor. In case that the emission signal EM is supplied to the emission line ESLi, the seventh transistor T7 is turned on to electrically connect the second electrode of the first transistor T1 to the second power line VSL together.

The sixth transistor T6 and the seventh transistor T7 are illustrated as being connected to the same emission line ESLi and turned on in response to the same emission signal EM. However, this is illustrated as an example, and the sixth transistor T6 and the seventh transistor T7 may be turned on independently of each other in response to different signals distinguished from each other. In another embodiment, in the pixel driver PDC according to an embodiment of the disclosure, one of the sixth transistor T6 and the seventh transistor T7 may be omitted.

The eighth transistor T8 may be connected between a second initialization voltage line VIL2 and the fourth node N4. For example, the eighth transistor T8 may include a gate connected to the i-th fourth scan line GBLi (hereinafter referred to as a second initialization line), a first electrode connected to the second initialization voltage line VIL2, and a second electrode connected to the fourth node N4. The eighth transistor T8 may be referred to as a second initialization transistor. The eighth transistor T8 may supply a second initialization voltage VINT2 to the fourth node N4 corresponding to the cathode of the light emitting element LD in response to a second initialization scan signal GB transmitted through the second initialization scan line GBLi. The cathode of the light emitting element LD may be initialized by the second initialization voltage VINT2.

Some of the second to eighth transistors T2, T3, T4, T5, T6, T7 and T8 may be simultaneously turned on in response to the same scan signal. For example, the eighth transistor T8 and the fifth transistor T5 may be simultaneously turned on in response to the same scan signal. For example, the eighth transistor T8 and the fifth transistor T5 may be operated in response to the same compensation scan signal GC. The eighth transistor T8 and the fifth transistor T5 may be simultaneously on/off in response to the same compensation scan signal GC. For example, the compensation scan line GCLi and the second initialization scan line GBLi may be provided as substantially a single scan line. Accordingly, the initialization of the cathode of the light emitting element LD and the compensation of the threshold voltage of the first transistor T1 may be performed at the same timing. However, this is illustrated as an example, and embodiments of the disclosure are not limited thereto.

According to an embodiment of the disclosure, the initialization of the cathode of the light emitting element LD and the compensation of the threshold voltage of the first transistor T1 may be performed by applying the same power voltage. For example, the compensation voltage line VCL and the second initialization voltage line VIL2 may be provided as substantially a single power voltage line. For example, the cathode initialization operation and the compensation operation of the driving transistor may be performed with one power voltage and thus, the design of the driver may be simplified. However, this is illustrated as an example, and embodiments of the disclosure are not limited thereto.

The first capacitor C1 may be disposed between the first node N1 and the third node N3. The first capacitor C1 may store a difference voltage between the first node N1 and the third node N3. The first capacitor C1 may be referred to as a storage capacitor.

The second capacitor C2 may be disposed between the third node N3 and the second power line VSL. For example, one electrode of the second capacitor C2 may be electrically connected to the second power line VSL which receives the second power voltage VSS, and another electrode of the second capacitor C2 may be electrically connected to the third node N3. The second capacitor C2 may store a charge corresponding to a difference voltage between the second power voltage VSS and the third node N3. The second capacitor C2 may be referred to as a hold capacitor. The second capacitor C2 may have a higher storage capacity than the first capacitor C1. Accordingly, the second capacitor C2 may minimize a voltage change of the third node N3 in response to a voltage change of the first node N1.

The light emitting element LD may be connected to the pixel driver PDC through the fourth node N4. The light emitting element LD may include an anode (or first electrode) connected to the first power line VDL and the cathode opposing the anode. The light emitting element LD may be connected to the pixel driver PDC through the cathode. For example, in the pixel PXij according to an embodiment of the disclosure, a connection node to which the light emitting element LD and the pixel driver PDC are connected may be the fourth node N4, and the fourth node N4 may correspond to a connection node between the first electrode of the sixth transistor T6 and the cathode of the light emitting element LD. Accordingly, a potential of the fourth node N4 may substantially correspond to a potential of the cathode of the light emitting element LD.

For example, the anode of the light emitting element LD may be connected to the first power line VDL and receive the first power voltage VDD that is a constant voltage, and the cathode may be connected to the first transistor T1 through the sixth transistor T6. For example, in this embodiment in which each of the first to eighth transistors T1 to T8 is an n-type transistor, a potential of the third node N3 corresponding to the source of the first transistor T1 that is a driving transistor may not be directly affected by characteristics of the light emitting element LD. Thus, even in case that the light emitting element LD is deteriorated, an influence on the transistors constituting the pixel driver PDC, particularly on a gate-source voltage of the driving transistor, may be reduced. For example, a change of the driving current due to the deterioration of the light emitting element LD may be reduced, thereby reducing afterimage defects of the display panel due to an increase in usage time and improving lifespan thereof.

As illustrated in FIG. 4B, the pixel PXij-1 may include a pixel driver PDC-1 including two transistors T1 and T2 and one first capacitor C1. The pixel driver PDC-1 may be connected to a light emitting element LD, a write scan line GWLi, a data line DLj, and a second power line VSL. The pixel driver PDC-1 illustrated in FIG. 4B may correspond to one in which the third to eighth transistors T3 to T8 and the second capacitor C2 are omitted in the pixel driver PDC illustrated in FIG. 4A.

Each of first and second transistors T1 and T2 may be an n-type or p-type transistor. A case in which each of the first and second transistors T1 and T2 is a n-type transistor is described as an example.

The first transistor T1 may include a gate connected to a first node N1, a first electrode connected to a second node N2, and a second electrode connected to a third node N3. The second node N2 may be a node connected to a side of a first power line VDL, and the third node N3 may be a node connected to a side of the second power line VSL. The first transistor T1 is connected to the light emitting element LD through the second node N2 and connected to the second power line VSL through the third node N3. The first transistor T1 may be a driving transistor.

The second transistor T2 may include a gate, which receives a write scan signal GW through the write scan line GWLi, a first electrode connected to the data line DLj, and a second electrode connected to the first node N1. The second transistor T2 may supply a data signal DATA to the first node N1 in response to the write scan signal GW transmitted through the write scan line GWLi.

The capacitor C1 may include an electrode connected to the first node N1, and an electrode connected to the third node N3. The capacitor C1 may store the data signal DATA transmitted to the first node N1.

The light emitting element LD may include an anode and a cathode. The anode of the light emitting element LD is connected to the first power line VDL, and the cathode is connected to the pixel driver PDC-1 through the second node N2. The cathode of the light emitting element LD may be connected to the first transistor T1. The light emitting element LD may emit light corresponding to an amount of current flowing in the first transistor T1 of the pixel driver PDC-1.

In this embodiment in which each of the first and second transistors T1 and T2 is an n-type transistor, the second node N2 to which the cathode of the light emitting element LD and the pixel driver PDC-1 are connected may correspond to a drain of the first transistor T1. For example, a change of a gate-source voltage of the first transistor T1 due to the light emitting element LD, may be prevented. Accordingly, a change of the driving current due to the deterioration of the light emitting element LD may be reduced, thereby reducing afterimage defects of the display panel due to an increase in usage time and improving lifespan thereof.

As illustrated in FIG. 4C, the pixel PXij-2 may include a pixel driver PDC-2 including six transistors T1, T2, T3, T4a, T5a and T6a and two capacitors C1 and C2.

The pixel driver PDC-2 may be connected to a light emitting element LD, a write scan line GWLi, a reset scan line GRLi, a compensation scan line GCLi, an i-th first emission line ESL1i (hereinafter referred to as a first emission line), an i-th second emission line ESL2i (hereinafter referred to as a second emission line), a data line DLj, a first power line VDL, a second power line VSL, a third power line VRL, and an initialization voltage line VIL.

The pixel driver PDC-2 illustrated in FIG. 4C may have a structure similar to a structure in which the fourth transistor T4 and the fifth transistor T5 are omitted in the pixel driver PDC illustrated in FIG. 4A. A surface area of the pixel driver PDC-2 illustrated in FIG. 4C may be less than a surface area of the pixel driver PDC illustrated in FIG. 4A, thereby more easily realizing high resolution.

Each of first to sixth transistors T1, T2, T3, T4a, T5a and T6a may be an n-type or p-type transistor. A case in which each of the first to sixth transistors T1, T2, T3, T4a, T5a and T6a is a n-type transistor is described as an example.

The first transistor T1 may include a gate connected to a first node N1, a first electrode connected to a second node N2, and a second electrode connected to a third node N3. The second node N2 may be a node connected to a side of the first power line VDL, and the third node N3 may be a node connected to a side of the second power line VSL. The first transistor T1 may be connected to the light emitting element LD through the second node N2 and connected to the second power line VSL through the third node N3. The first transistor T1 may be a driving transistor.

The second transistor T2 may include a gate, which receives a write scan signal GW through the write scan line GWLi, a first electrode connected to the data line DLj, and a second electrode connected to the first node N1. The second transistor T2 may supply a data signal DATA to the first node N1 in response to the write scan signal GW transmitted through the write scan line GWLi.

The third transistor T3 may be connected between the first node N1 and the reference voltage line VRL. A first electrode of the third transistor T3 may receive a reference voltage VREF through the reference voltage line VRL, and a second electrode of the third transistor T3 may be connected to the first node N1. A gate of the third transistor T3 may receive a reset scan signal GR through the reset scan line GRLi. In case that the reset scan signal GR is supplied to the reset scan line GRLi, the third transistor T3 may be turned on to supply the reference voltage VREF to the first node N1.

The fourth transistor T4a may be connected between the first transistor T1 and the light emitting element LD. For example, a gate of the fourth transistor T4a may receive a first emission signal EM1 through the first emission line ESL1i. A first electrode of the fourth transistor T4a may be connected to a cathode of the light emitting element LD through a fourth node N4, and a second electrode of the fourth transistor T4a may be connected to the first electrode of the first transistor T1 through the second node N2. The fourth transistor T4a may be referred to as a first emission control transistor. In case that the first emission signal EM1 is supplied to the first emission line ESL1i, the fourth transistor T4a may be turned on to electrically connect the light emitting element LD the first transistor T1 together.

The fifth transistor T5a may be connected between the second power line VSL and the third node N3. A first electrode of the fifth transistor T5a may be connected to the second electrode of the first transistor T1 through the third node N3, and a second electrode of the fifth transistor T5a may receive a second power voltage VSS through the second power line VSL. A gate of the fifth transistor T5a may be electrically connected to the second emission line ESL2i. The fifth transistor T5a may be referred to as a second emission control transistor. In case that a second emission signal EM2 is supplied to the second emission line ESL2i, the fifth transistor T5a is turned on to electrically connect the second electrode of the first transistor T1 to the second power line VSL together.

The fourth transistor T4a and the fifth transistor T5a may be connected to the first and second emission lines ESL11 and ESL2i distinguished from each other, and be turned on in response to the first and second emission signals EM1 and EM2 distinguished from each other, respectively. For example, the fourth transistor T4a and the fifth transistor T5a may be turned on independently of each other. However, this is just an example, and embodiments of the disclosure are not limited thereto. For example, the fourth transistor T4a and the fifth transistor T5a may be connected to the same emission line and controlled by the same emission signal. In another embodiment, in the pixel driver PDC-2 according to an embodiment of the disclosure, one of the fourth transistor T4a and the fifth transistor T5a may be omitted.

The sixth transistor T6a may be connected between the initialization voltage line VIL and the fourth node N4. For example, the sixth transistor T6a may include a gate connected to the compensation scan line GCLi, a first electrode connected to the initialization voltage line VIL, and a second electrode connected to the fourth node N4. The sixth transistor T6a may be referred to as an initialization transistor. The sixth transistor T6a may supply an initialization voltage VINT to the fourth node N4 corresponding to the cathode of the light emitting element LD in response to a compensation scan signal GC transmitted through the compensation scan line GCLi. The cathode of the light emitting element LD may be initialized by the initialization voltage VINT.

A first capacitor C1 may be disposed between the first node N1 and the third node N3. The first capacitor C1 may store a difference voltage between the first node N1 and the third node N3. The first capacitor C1 may be referred to as a storage capacitor.

A second capacitor C2 may be disposed between the third node N3 and the second power line VSL. For example, one electrode of the second capacitor C2 may be connected to the second power line VSL which receives the second power voltage VSS, and another electrode of the second capacitor C2 may be connected to the third node N3. The second capacitor C2 may store a charge corresponding to a difference voltage between the second power voltage VSS and the third node N3. The second capacitor C2 may be referred to as a hold capacitor.

The light emitting element LD may include an anode and a cathode. The anode of the light emitting element LD is connected to the first power line VDL, and the cathode thereof is connected to the pixel driver PDC-2 through the fourth node N4. The cathode of the light emitting element LD may be connected to the first transistor T1 through the fourth transistor T4a. The light emitting element LD may emit light corresponding to an amount of current flowing in the first transistor T1 of the pixel driver PDC-2.

In this embodiment in which each of the first to sixth transistors T1, T2, T3, T4a, T5a and T6a is an n-type transistor, a potential of the third node N3 corresponding to the source of the first transistor T1 that is a driving transistor may not be directly affected by characteristics of the light emitting element LD. Thus, even in case that the light emitting element LD is deteriorated, an influence on the transistors constituting the pixel driver PDC-2, particularly on a gate-source voltage of the driving transistor, may be reduced. For example, a change of the driving current due to the deterioration of the light emitting element LD may be reduced, thereby reducing afterimage defects of the display panel due to an increase in usage time and improving lifespan thereof.

FIGS. 4A, 4B, and 4C illustrate the circuits for the pixel drivers PDC, PDC-1 and PDC-2 according to an embodiment of the disclosure, and in the display panel according to an embodiment of the disclosure, as long as the circuit is a circuit connected to the cathode of the light emitting element LD, the number or arrangement relationship of the transistors and the number or arrangement relationship of the capacitors may be variously designed, and are not limited thereto.

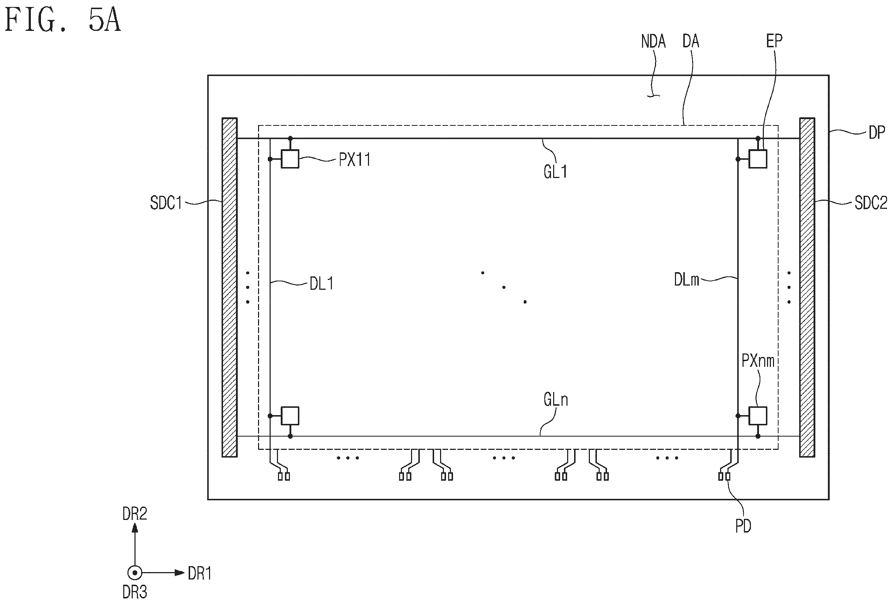

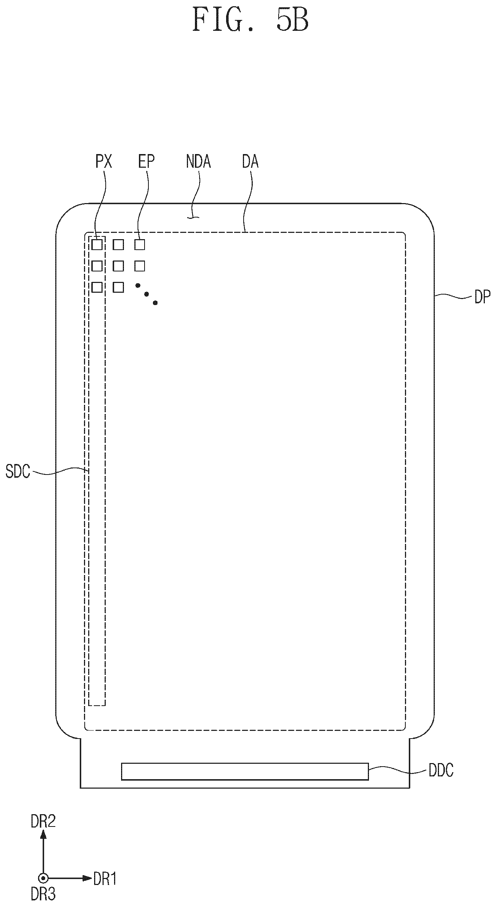

FIGS. 5A and 5B are each a schematic plan view illustrating a display panel according to an embodiment of the disclosure. In each of FIGS. 5A and 5B, some components are omitted. Hereinafter, embodiments of the disclosure will be described with reference to FIGS. 5A and 5B.

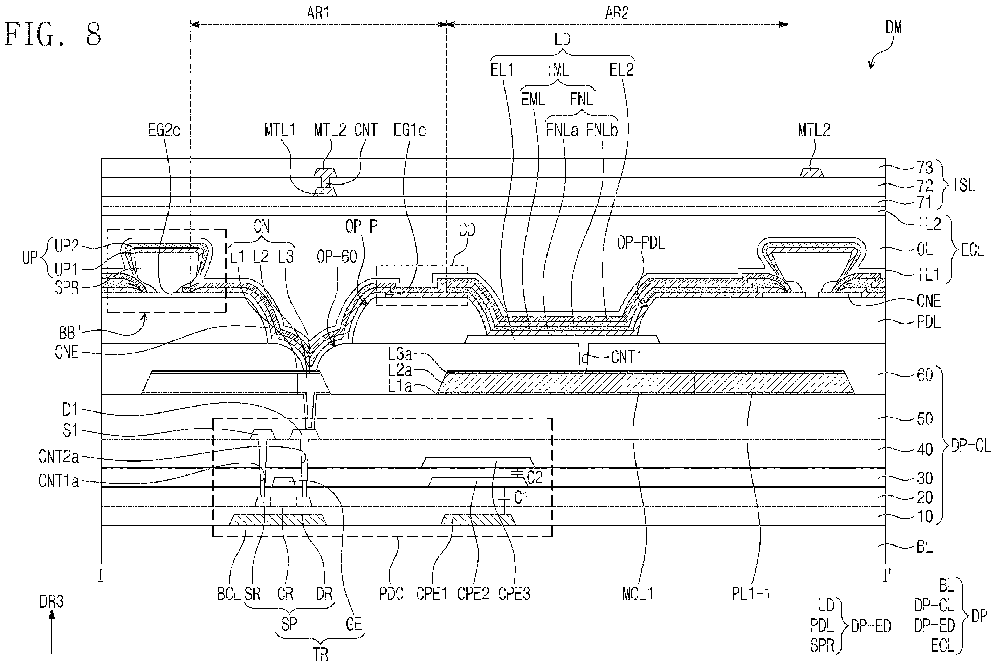

Referring to FIG. 5A, a display panel DP may be divided into a display area DA and a non-display area NDA (or a peripheral area). The display area DA may include multiple emission portions EP. The emission portions EP may be areas in which light is emitted by the pixels PXij (see FIG. 3), respectively. For example, each of the emission portions EP may correspond to an emission opening portion OP-PDL (see FIG. 8) to be described later.

The non-display area NDA may be disposed adjacent to the display area DA. The non-display area NDA is illustrated as having a shape surrounding an edge of the display area DA. However, this is illustrated as an example, and the non-display area NDA may be disposed at one side of the display area DA or omitted, and is not limited thereto.

A data driver DDC may be provided in the form of a separate driving chip independent of the display panel DP, and be electrically connected to the display panel DP. However, this is illustrative, and the data driver DDC may be formed in the same process as a scan driver SDC so as to constitute the display panel DP, and is not limited thereto.

The display panel DP may have a shape having a length corresponding to the first direction DR1 that is greater than a length corresponding to the second direction DR2. The display area DA in which multiple pixels PX11 to PXnm arranged in an n-row by m-column array is disposed is illustrated as an example. The display panel DP may include multiple scan drivers SDC1 and SDC2. As an example, the scan drivers SDC1 and SDC2 are illustrated as including a first scan driver SDC1 and a second scan driver SDC2 which are disposed apart from each other in the first direction DR1.

The first scan driver SDC1 may be electrically connected to some of scan lines GL1 to GLn, and the second scan driver SDC2 may be electrically connected to others of the scan lines GL1 to GLn. For example, the first scan driver SDC1 may be electrically connected to odd-numbered scan lines of the scan lines GL1 to GLn, and the second scan driver SDC2 may be electrically connected to even-numbered scan lines of the scan lines GL1 to GLn.

For ease explanation, FIG. 5A illustrates pads PD of data lines DL1 to DLm. The pads PD may be defined at ends of the data lines DL1 to DLm. The data lines DL1 to DLm may be electrically connected to the data driver DDC (see FIG. 3) through the pads PD.

Unlike the embodiment illustrated in FIG. 5A, the pads PD may be divided and arranged at positions, which are spaced apart from each other with respect to the display area DA therebetween, of the non-display area NDA. For example, some of the pads PD may be disposed at an upper side, i.e., a side adjacent to a first scan line GL1 of the scan lines GL1 to GLn, and others of the pads PD may be disposed at a lower side, i.e., a side adjacent to the last scan line GLn of the scan lines GL1 to GLn. The pads PD electrically connected to odd-numbered data lines of the data lines DL1 to DLm may be disposed at the upper side, and the pads PD electrically connected to even-numbered data lines of the data lines DL1 to DLm may be disposed at the lower side.

Although not illustrated, the display panel DP may include multiple lower data drivers electrically connected to the pads PD disposed at the lower side. However, this is illustrative, and the display panel DP may include one lower data driver electrically connected to the pads PD disposed at the lower side.

In FIG. 5A, in the display panel DP, the scan drivers SDC1 and SDC2 may be disposed in the display area DA, and accordingly, some of the emission portions EP disposed in the display area DA may overlap the scan drivers SDC1 and SDC2 in a plan view.

Referring to FIG. 5B, a scan driver SDC and a data driver DDC may be mounted on a display panel DP. The scan driver SDC may be disposed in a display area DA, and the data driver DDC may be disposed in a non-display area NDA. The scan driver SDC may overlap at least some of multiple emission portions EP disposed in the display area DA in a plan view. Compared to a typical display panel in which a scan driver is disposed in a non-display area, the scan driver SDC may be disposed in the display area DA, thereby reducing a surface area of the non-display area NDA and easily achieving a display device with a thinned bezel.

Unlike the embodiment illustrated in FIG. 5B, the scan driver SDC may be provided as two portions separated from each other as in FIG. 5A. The two scan drivers SDC may be disposed apart from each other at left and right sides with a center of the display area DA therebetween. In another embodiment, the scan driver SDC may be provided in plurality more than two in number, and is not limited thereto.

FIG. 5B illustrates one example of the display panel DP, and the scan driver SDCmay be disposed in the display area DA. Here, some of the emission portions EP disposed in the display area DA may overlap the scan driver SDCin a plan view.

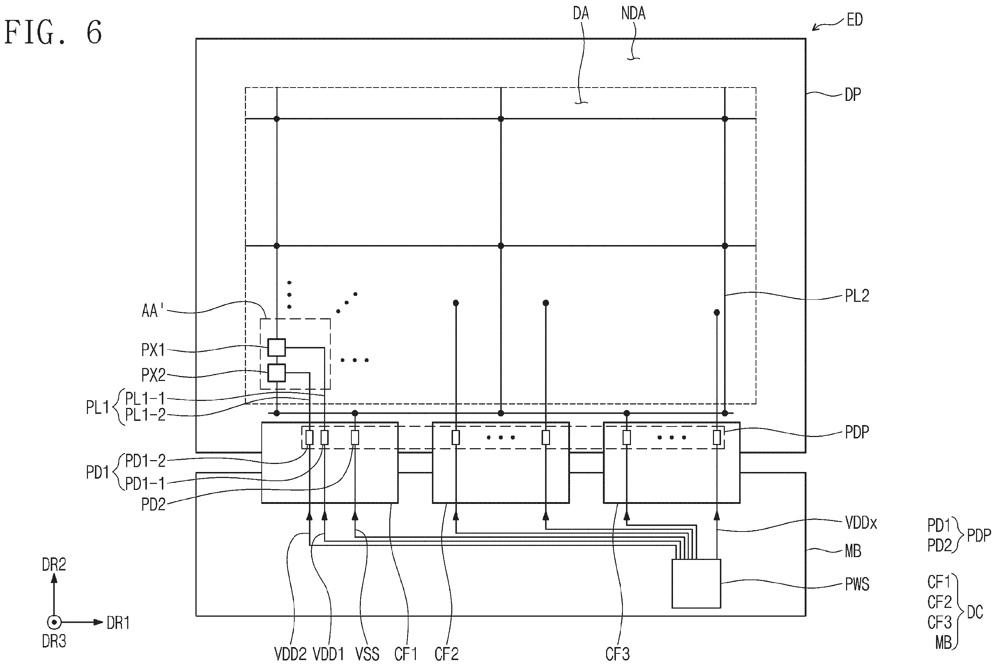

FIG. 6 is a schematic plan view of a display panel and a driving circuit part according to an embodiment of the disclosure.

Referring to FIG. 6, an electronic device ED according to an embodiment of the disclosure may include a display panel DP and a driving circuit part DC. The driving circuit part DC may be electrically connected to the display panel DP. The driving circuit part DC may include a main circuit board MB and flexible films CF1, CF2 and CF3.

The pixels PXij (see FIG. 3) may be disposed in a display area DA of the display panel DP. Th pixels PXij may be arranged in the first direction DR1 and the second direction DR2. FIG. 6 illustrates some pixels PX1 and PX2 of the pixels PXij. Th pixels PX1 and PX2 may include a first pixel PX1 and a second pixel PX2. Each of the first pixel PX1 and the second pixel PX2 may be one pixel of the pixels PXij. The first pixel PX1 and the second pixel PX2 may have substantially the same configuration.

The flexible films CF1, CF2 and CF3 may be electrically connected to the display panel DP. The flexible films CF1, CF2 and CF3 may be electrically connected to a pad portion PDP of the display panel DP disposed in a non-display area NDA. The flexible film CF provides the display panel DP with an electrical signal for driving the display panel DP. The electrical signal may be generated from the flexible films CF1, CF2 and CF3, or generated from the main circuit board MB. The flexible films CF1, CF2 and CF3 may include a first flexible film CF1, a second flexible film CF2, and a third flexible film CF3 which are aligned in the first direction DR1. Unlike the embodiment illustrated in FIG. 6, the flexible films CF1, CF2 and CF3 may be provided as a single flexible film or provided as multiple flexible films that are four or more.

The main circuit board MB may include various driving circuits for driving a display module DM (see FIG. 8), a connector for supplying power, or the like. As an example, FIG. 6 illustrates only a power supply PWS disposed on the main circuit board MB.

The pad portion PDP may include first pads PD1 and second pads PD2. The pad portion PDP may be a portion to which the flexible films CF1, CF2 and CF3 are electrically connected. The pad portion PDP may include various pads such as a data pad (not illustrated) or an input pad (not illustrated), but, in an embodiment of the disclosure, only the first pads PD1 and the second pads PD2 which are associated with voltages supplied to the pixels PX1 and PX2 are illustrated.

The pad portion PDP may overlap the non-display area NDA. The pad portion PDP may be disposed adjacent to a lower end of the display panel DP. However, the arrangement of the pad portion PDP is not limited thereto, and the pad portion PDP may be disposed at various positions.

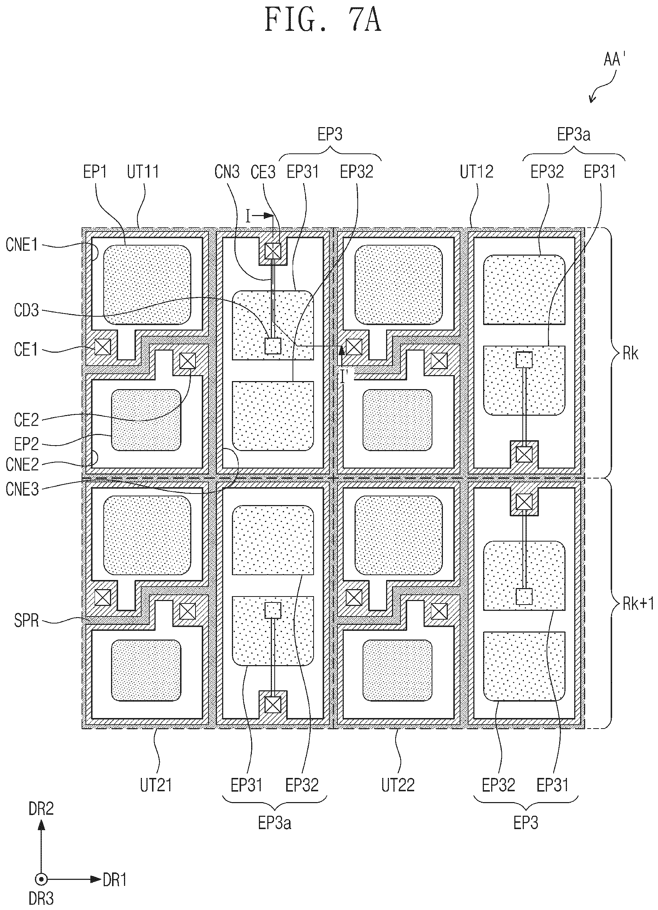

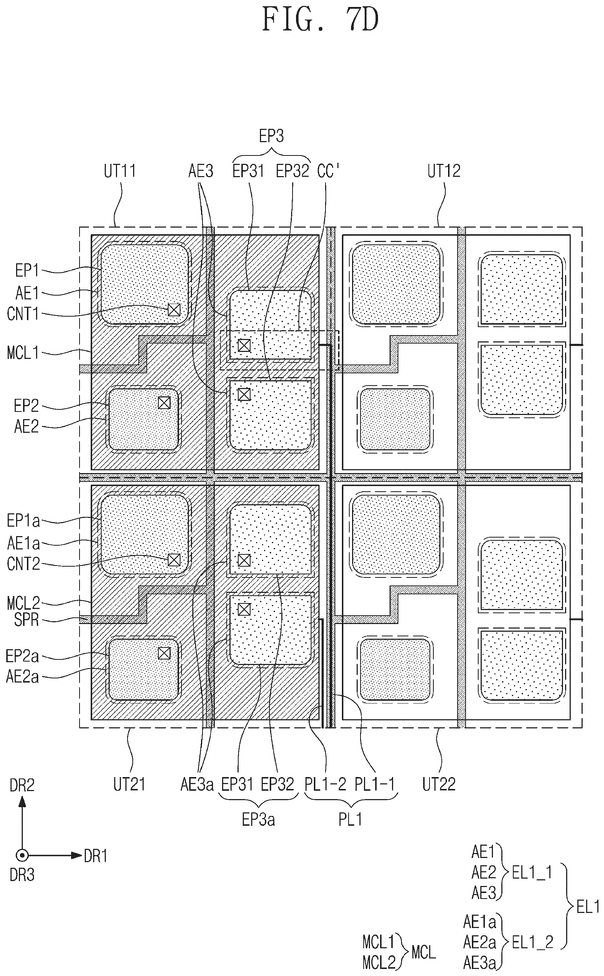

The first pads PD1 may be disposed in the non-display area NDA and receive first and second voltages VDD1 and VDD2. The first pads PD1 may be electrically connected to the pixels PX1 and PX2 and provide the first and second voltages VDD1 and VDD2 to the pixels PX1 and PX2. The first pads PD1 may include a (1-1)-th pad PD1-1 which receives the first voltage VDD1, and a (1-2)-th pad PD1-2 which receives the second voltage VDD2. The (1-1)-th pad PD1-1 may be electrically connected to the first pixel PX1 and provide the first voltage VDD1 to a (1-1)-th electrode EL1_1 (see FIG. 7D) of the first pixel PX1, and the (1-2)-th pad PD1-2 may be electrically connected to the second pixel PX2 and provide the second voltage VDD2 to a (1-2)-th electrode EL1_2 (see FIG. 7D) of the second pixel PX2. The second pads PD2 may be disposed in the non-display area NDA and receive a second power voltage VSS. The second pads PD2 may be electrically connected to the pixels PX1 and PX2 and provide the second power voltage VSS to a second electrode EL2 (see FIG. 7A) of each of the pixels PX1 and PX2.

The display panel DP may include a first power line PL1 and a second power line PL2. The first power line PL1 may include a (1-1)-th power line PL1-1 and a (1-2)-th power line PL1-2. The (1-1)-th power line PL1-1 and the (1-2)-th power line PL1-2 may overlap the display area DA. Each of the (1-1)-th power line PL1-1 and the (1-2)-th power line PL1-2 may extend in the second direction DR2. Although FIG. 6 illustrates the first power line PL1 including two power lines that are the (1-1)-th power line PL1-1 and the (1-2)-th power line PL1-2, embodiments of the disclosure are not limited, and the first power line PL1 may further include a power line electrically connected to each of the pixels disposed in the display area DA.

The (1-1)-th power line PL1-1 may be electrically connected to the first pixel PX1. The (1-1)-th power line PL1-1 may be electrically connected to the (1-1)-th electrode EL1_1 (see FIG. 7D) of the first pixel PX1 and supply the first voltage VDD1 received from the (1-1)-th pad PD1-1. The (1-2)-th power line PL1-2 may be electrically connected to the (1-2)-th electrode EL1_2 (see FIG. 7D) of the second pixel PX2 and supply the second voltage VDD2 received from the (1-2)-th pad PD1-2.

The second power line PL2 may overlap the display area DA and extend in the first direction DR1 or the second direction DR2. The second power line PL2 may cross the display area DA in the first direction DR1 or the second direction DR2. The second power line PL2 may be provided in plurality. The second power lines PL2 may extend in the second direction DR2 and be arranged in the first direction DR1, and extend in the first direction DR1 and be arranged in the second direction DR2. In the second power lines PL2, one second power line PL2 may be disposed in each of pixel columns extending in the second direction DR2, and one second power line PL2 may be disposed in each of pixel rows extending in the first direction DR1.

The second power lines PL2 may be electrically connected to the second pads PD2. The second power lines PL2 PL1 may be electrically connected to the pixels PXij (see FIG. 3), respectively. For example, the second power lines PL2 may be electrically connected to the transistors of the pixels PXij. The second power lines PL2 may be electrically connected to the pixels PXij and supply the second power voltage VSS received from the second pads PD2.

The power supply PWS may be disposed on the main circuit board MB. The power supply PWS may generate the first power voltages VDD1 to VDDx and the second power voltage VSS. The pad portion PDP may be electrically connected to the power supply PWS. The power supply PWS may be electrically connected to the first power line PL1 and the second power line PL2 through the pad portion PDP. The power supply PWS may apply the first voltage VDD1 to the (1-1)-th pad PD1-1, apply the second voltage VDD2 to the (1-2)-th pad PD1-2, and apply the second power voltage VSS to the second pads PD2. As a result, the power supply PWS may apply the first voltage VDD1 to the first pixel PX1, and apply the second voltage VDD2 to the second pixel PX2. Although not illustrated, the power supply PWS may apply a third voltage VDD3 to a x-th voltage VDDx to a (1-3)-th pad to a (1-x)-th pad, respectively.

FIGS. 7A to 7D are each an enlarged schematic plan view of a partial area of a display panel according to an embodiment of the disclosure. For example, FIG. 7A is an enlarged schematic view of area AA' illustrated in FIG. 6.

As an example, FIG. 7A illustrates emission units UT11, UT12, UT21 and UT22 in two rows and two columns. Referring to FIG. 7A, emission portions in a first row Rk include emission portions constituting a first row and first column emission unit UT11 and a first row and second column emission unit UT12, and emission portions in a second row Rk+1 include emission portions constituting a second row and first column emission unit UT21 and a second row and second column emission unit UT22. The first row and first column emission unit UT11 is a component included in the first pixel PX1 illustrated in FIG. 6, and the second row and first column emission unit UT21 is a component included in the second pixel PX2 illustrated in FIG. 6. The row may correspond to the first direction DR1, and the column may correspond to the second direction DR2.

Each of emission portions EP1, EP2 and EP3 may correspond to an emission opening portion OP-PDL (see FIG. 8) to be described later. For example, each of the emission portions EP1, EP2 and EP3 may be an area in which light is emitted by the light emitting element described above. The emission portions EP1, EP2 and EP3 may correspond to units constituting an image displayed on the display panel DP (see FIG. 2A). For example, each of the emission portions EP1, EP2, and EP3 may correspond to an area defined by the emission opening portion OP-PDL (see FIG. 8) to be described later, particularly to an area defined by a bottom surface of the emission opening portion OP-PDL.

The emission portions EP1, EP2, and EP3 may include a first emission portion EP1, a second emission portion EP2, and a third emission portion EP3. For example, each of the first pixel PX1 (see FIG. 6) and the second pixel PX2 (see FIG. 6) may include the first emission portion EP1, the second emission portion EP2, and the third emission portion EP3. Each of the first pixel PX1 and the second pixel PX2 may include three sub-pixels. The three sub-pixels may correspond to the first emission portion EP1, the second emission portion EP2, and the third emission portion EP3, respectively.

The first emission portion EP1, the second emission portion EP2, and the third emission portion EP3 may emit light of different colors from each other. For example, the first emission portion EP1 may emit red light, the second emission portion EP2 may emit green light, and the third emission portion EP3 may emit blue light. However, a combination of colors is not limited thereto. At least two of the first to third emission portions EP1, EP2 and EP3 may emit light of the same color. For example, the first to third emission portions EP1, EP2 and EP3 may all emit the blue light, or all emit white light.

Among the first to third emission portions EP1, EP2 and EP3, the third emission portion EP3 which displays light emitted by a third light emitting element may include two sub-emission portions EP31 and EP32 spaced apart from each other in the second direction DR2. However, this is illustrated as an example. The third emission portion EP3 may be provided as one pattern having a shape of one body like the first and second emission portions EP1 and EP2, or at least one of the first and second emission portions EP1 and EP2 may include sub-emission portions spaced apart from each other, and is not limited thereto.

The emission portions in the first row Rk may include first to third emission portions EP1, EP2 and EP3 constituting the first row and first column emission unit UT11 and first to third emission portions EP1, EP2 and EP3a constituting the first row and second column emission unit UT12, and the emission portions in the second row Rk+1 include first to third emission portions EP1, EP2 and EP3a constituting the second row and first column emission unit UT21 and first to third emission portions EP1, EP2 and EP3 constituting the second row and second column emission unit UT22.

The emission portions constituting the first row and first column emission unit UT11 and the emission portions constituting the second row and second column emission unit UT22 may be substantially the same in terms of the shape. The emission portions constituting the first row and second column emission unit UT12 and the emission portions constituting the second row and first column emission unit UT21 may be substantially the same in terms of the shape. The shape of the emission portions constituting the first row and first column emission unit UT11 may be different from the shape of the emission portions constituting the first row and second column emission unit UT12. For example, a portion of the emission portions in the first row Rk and a portion of the emission portions in the second row Rk+1 may have a symmetrical shape.

The third emission portion EP3a of the second row and first column emission unit UT21 and the third emission portion EP3 of the first row and first column emission unit UT11 may have shapes and arrangement configurations having line symmetry about an axis parallel to the first direction DR1, and the third emission portion EP3 of the second row and second column emission unit UT22 and the third emission portion EP3a of the first row and second column emission unit UT12 may have shapes and arrangement configurations having line symmetry about an axis parallel to the first direction DR1. However, this is illustrative, and embodiments of the disclosure are not limited thereto.

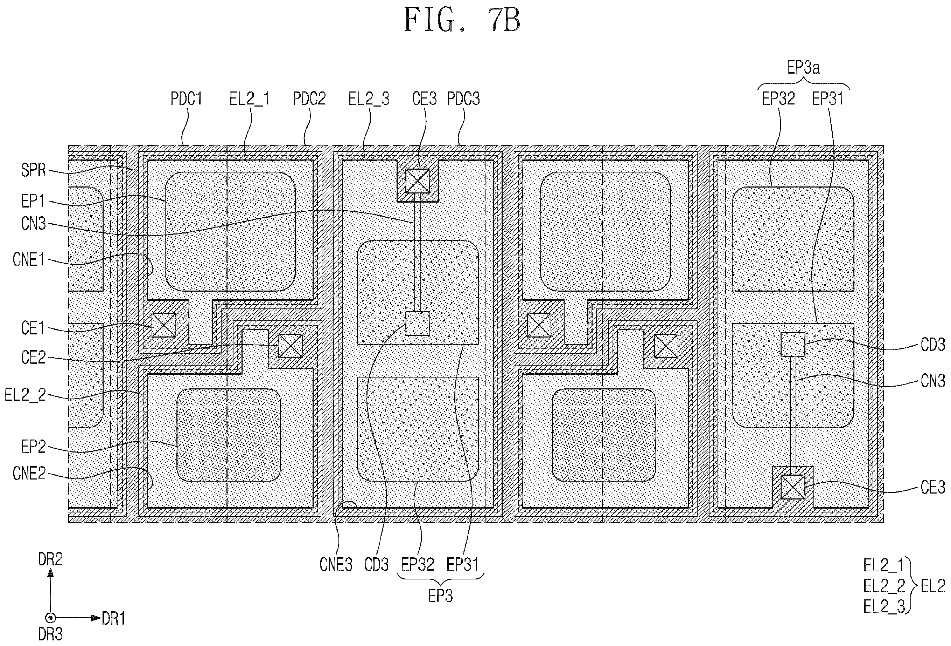

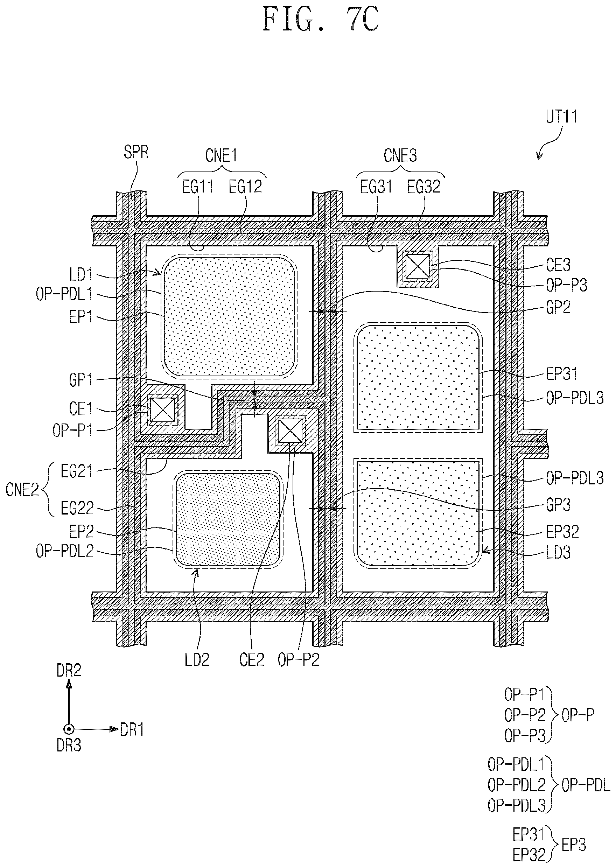

FIG. 7B illustrates emission portions arranged in one row. For ease explanation, FIG. 7B illustrates multiple second electrodes EL2_1, EL2_2 and EL2_3 (or referred to as cathodes), multiple pixel drivers PDC1, PDC2 and PDC3, first to third connection electrodes CNE1, CNE2 and CNE3, and a separator SPR. Among components of a display panel, FIG. 7C illustrates a separator SPR, multiple emission portions EP1, EP2 and EP3 disposed within areas divided by the separator SPR, and multiple connection electrodes CNE1, CNE2 and CNE3.

Referring to FIGS. 7B and 7C, first to third cathodes (or second electrodes) EL2_1, EL2_2 and EL2_3 may be separated and electrically disconnected from each other by the separator SPR. The first to third cathodes EL2_1, EL2_2 and EL2_3 may be referred to as second sub-electrodes in an embodiment of the disclosure. One emission unit UT11 may include three emission portions EP1, EP2 and EP3. Accordingly, the emission unit UT11 may include three cathodes EL2_1, EL2_2 and EL2_3, three pixel drivers PDC1, PDC2 and PDC3, and three connection electrodes CNE1, CNE2 and CNE3. However, this is illustrated as an example, and the number and arrangement of the emission portions included in the emission unit UT11 may be variously designed, and are not limited thereto.

The first to third pixel drivers PDC1, PDC2 and PDC3 may be electrically connected to first to third light emitting elements LD1, LD2 and LD3 including the first to third emission portions EP1, EP2 and EP3, respectively. In the disclosure, in case that components are "connected", it includes not only a case in which the components come into direct physical contact to be coupled, but also a case in which the components are electrically connected.

Respective areas in which the first to third pixel drivers PDC1, PDC2 and PDC3 are defined in a plan view as in FIG. 7B may correspond to a unit in which transistor and capacitor elements constituting the pixel driver PDC (see FIG. 4A) for driving a light emitting element of a pixel are repeatedly arranged.

The first to third pixel drivers PDC1, PDC2, and PDC3 may be disposed in sequence in the first direction DR1. The arranged positions of the first to third pixel drivers PDC1, PDC2 and PDC3 may be independently designed irrespective of the positions or shapes of the first to third emission portions EP1, EP2 and EP3.

For example, the first to third pixel drivers PDC1, PDC2 and PDC3 may be designed so as to be disposed on positions different from the areas divided and defined by the separator SPR, i.e., the disposed positions of the first to third cathodes EL2_1, EL2_2 and EL2_3, or so as to have different shapes and surface areas from the first to third cathodes EL2_1, EL2_2 and EL2_3. In another embodiment, the first to third pixel drivers PDC1, PDC2 and PDC3 may be designed to be disposed so as to overlap the positions on which the first to third emission portions EP1, EP2 and EP3 are present, respectively, and to have shapes having surface areas similar to the areas divided and defined by the separator SPR, for example, the first to third cathodes EL2_1, EL2_2 and EL2_3.

The first to third pixel drivers PDC1, PDC2 and PDC3 each have a rectangular shape, the first to third emission portions EP1, EP2 and EP3 are arranged in smaller surface areas and in a different configuration compared to the pixel drivers, and the first to third cathodes EL2_1, EL2_2 and EL2_3 are disposed on positions overlapping the first to third emission portions EP1, EP2 and EP3, respectively, and have irregular shapes.

Accordingly, as illustrated in FIG. 7B, the first pixel driver PDC1 may be disposed on a position partially overlapping the first emission portion EP1, the second emission portion EP2, and another adjacent emission unit. The second pixel driver PDC2 may be disposed on a position overlapping the first emission portion EP1, the second emission portion EP2, and the third cathode EL2_3. The third pixel driver PDC3 may be disposed on a position overlapping the third emission portion EP3. However, this is illustrated as an example, and the positions of the first to third pixel drivers PDC1, PDC2 and PDC3 may be designed in various configurations and arrangements independently of the first to third emission portions EP1, EP2 and EP3, and are not limited thereto.

The emission unit UT11 may include the first to third connection electrodes CNE1, CNE2 and CNE3. The first connection electrode CNE1 may electrically connect the first pixel driver PDC1 to the first light emitting element LD1 which provides the first emission portion EP1 (or in which the first emission portion EP1 is defined), the second connection electrode CNE2 may electrically connect the second pixel driver PDC2 to the second light emitting element LD2 which provides the second emission portion EP2, and the third connection electrode CNE3 may electrically connect the third pixel driver PDC3 to the third light emitting element LD3 which provides the third emission portion EP3. Each of the first to third light emitting elements LD1, LD2 and LD3 may include a first electrode EL1, an intermediate layer IML disposed on the first electrode EL1, and a second electrode EL2 disposed on the intermediate layer IML.

For example, the first to third connection electrodes CNE1, CNE2 and CNE3 may electrically connect the first to third cathodes EL2_1, EL2_2 and EL2_3 to the first to third pixel drivers PDC1, PDC2 and PDC3, respectively, in one-to-one correspondence. For example, the first connection electrode CNE1 may be electrically connected to the first pixel driver PDC1 and the first cathode EL2_1, the second connection electrode CNE2 may be electrically connected to the second pixel driver PDC2 and the second cathode EL2_2, and the third connection electrode CNE3 may be electrically connected to the third pixel driver PDC3 and the third cathode EL2_3.

Each of the first to third connection electrodes CNE1, CNE2 and CNE3 may be disposed on a pixel defining film PDL (see FIG. 8) to be described later. The first to third connection electrodes CNE1, CNE2 and CNE3 may have ring (or rectangular) shapes which surround corresponding first to third emission portions EP1, EP2 and EP3, respectively. The first to third connection electrodes CNE1, CNE2 and CNE3 are each illustrated as having a closed ring (or rectangular) shape as an example, but are not limited thereto. For example, at least a portion of the first to third connection electrodes CNE1, CNE2 and CNE3 may have an open ring (or rectangular) shape with a cut portion.

As the first to third connection electrodes CNE1, CNE2 and CNE3 have the ring (or rectangular) shapes, a degree of freedom of the connected positions of the first to third connection electrodes CNE1, CNE2 and CNE3 and the first to third pixel drivers PDC1, PDC2 and PDC3 may be improved. For example, the first connection electrode CNE1 may be electrically connected to the first pixel driver PDC1 through a first connection portion CE1, the second connection electrode CNE2 may be electrically connected to the second pixel driver PDC2 through a second connection portion CE2, and the third connection electrode CNE3 may be electrically connected to the third pixel driver PDC3 through a connection line CN3. For example, connection lines additionally connected to the first and second connection electrodes CNE1 and CNE2 may be omitted.

The one connection line CN3 may electrically connect the third pixel driver PDC3 to the third light emitting element LD3 which provides the third emission portion EP3. For example, the connection line CN3 may correspond to a node (see the fourth node N4 in FIG. 4A, the second node N2 in FIG. 4B, or the fourth node N4 in FIG. 4C) through which the light emitting element LD (see FIG. 4A) is electrically connected to the pixel driver (the pixel driver PDC in FIG. 4A, the pixel driver PDC-1 in FIG. 4B, or the pixel driver PDC-2 in FIG. 4C).

The connection line CN3 may include a third connection portion CE3 and a driving connection portion CD3. The third connection portion CE3 may be provided on one side of the connection line CN3, and the driving connection portion CD3 may be provided on another side of the connection line CN3.

The driving connection portion CD3 may be a portion, which is electrically connected to the pixel driver PDC3, of the connection line CN3. The driving connection portion CD3 may be electrically connected to one electrode of a transistor constituting the pixel driver PDC3. For example, the driving connection portion CD3 may be electrically connected to the drain of the sixth transistor T6 illustrated in FIG. 4A, the drain of the first transistor T1 illustrated in FIG. 4B, or the drain of the fourth transistor T4a illustrated in FIG. 4C. Accordingly, a position of the driving connection portion CD3 may correspond to a position of a transistor, which is physically connected to the connection line CN3, of a pixel driver. The third connection portion CE3 may be a portion, which is electrically connected to the third light emitting element LD3, of the connection line CN3. The third connection portion CE3 may be electrically connected to the third connection electrode CNE3.

The first connection electrode CNE1 may include a first edge EG11 which surrounds at least a portion of the first emission portion EP1, and a second edge EG12 which surrounds the first edge EG11. The second connection electrode CNE2 may include a first edge EG21 which surrounds at least a portion of the second emission portion EP2, and a second edge EG22 which surrounds the first edge EG21. The third connection electrode CNE3 may include a first edge EG31 which surrounds at least a portion of the third emission portion EP3, and a second edge EG32 which surrounds the first edge EG31.

The first to third connection electrodes CNE1, CNE2 and CNE3 may be arranged apart from each other. For example, among the first to third connection electrodes CNE1, CNE2 and CNE3, gaps GP1, GP2 and GP3 between multiple connection electrodes adjacent to each other may overlap the separator SPR. For example, the first edges EG11, EG21 and EG31 of the first to third connection electrodes CNE1, CNE2 and CNE3 may not be covered by the separator SPR, and the second edges EG12, EG22 and EG32 of the first to third connection electrodes CNE1, CNE2 and CNE3 may overlap the separator SPR. The second edges EG12, EG22 and EG32 of the first to third connection electrodes CNE1, CNE2 and CNE3 may be covered by the separator SPR.

The first to third connection portions CE1, CE2 and CE3 may be disposed on positions which do not overlap the first to third emission portions EP1, EP2 and EP3 in a plan view, respectively. For example, an emission opening portion OP-PDL (see FIG. 8) and through-holes OP-P spaced apart from the emission opening portion OP-PDL (see FIG. 8) may be defined in the pixel defining film PDL.

The through-holes OP-P may include a first through-hole OP-P1, a second through-hole OP-P2, and a third through-hole OP-P3. The first to third connection portions CE1, CE2 and CE3 may be arranged to correspond (or to overlap) to the first to third through-holes OP-P1, OP-P2 and OP-P3, respectively. The emission opening portion OP-PDL may include a first emission opening portion OP-PDL1, a second emission opening portion OP-PDL2, and a third emission opening portion OP-PDL3. The first to third emission portions EP1, EP2 and EP3 may be defined to correspond (or to overlap) to the first to third emission opening portions OP-PDL1, OP-PDL2 and OP-PDL3, respectively. Thus, the first to third connection portions CE1, CE2 and CE3 may be disposed on positions spaced apart from the first to third emission portions EP1, EP2 and EP3.

The first to third connection electrodes CNE1, CNE2 and CNE3 may be disposed on the pixel defining film PDL (see FIG. 8). In a plan view, the first connection electrode CNE1 may surround the first emission opening portion OP-PDL1, the second connection electrode CNE2 may surround the second emission opening portion OP-PDL2, and the third connection electrode CNE3 may surround the third emission opening portion OP-PDL3.

The first to third cathodes EL2_1, EL2_2 and EL2_3 may be electrically connected to the first to third connection electrodes CNE1, CNE2 and CNE3, respectively. For example, bottom surfaces of the first to third cathodes EL2_1, EL2_2 and EL2_3 may be electrically connected to (or in contact with) top surfaces of the first to third connection electrodes CNE1, CNE2 and CNE3, respectively. Thus, contact reliability (or connection stability) between the first to third cathodes EL2_1, EL2_2 and EL2_3 and the first to third connection electrodes CNE1, CNE2 and CNE3 may be more improved.

Connection areas at which the first to third cathodes EL2_1, EL2_2 and EL2_3 and the first to third connection electrodes CNE1, CNE2 and CNE3 are electrically connected may surround at least a portion of each of the first to third emission opening portions OP-PDL1, OP-PDL2 and OP-PDL3. The first to third cathodes EL2_1, EL2_2 and EL2_3 and the first to third connection electrodes CNE1, CNE2 and CNE3 may be electrically connected to each other at areas adjacent to the separator SPR, and each of the connection areas may be defined to be adjacent to the separator SPR. For example, the first to third cathodes EL2_1, EL2_2 and EL2_3 and the first to third connection electrodes CNE1, CNE2 and CNE3 may not be electrically connected at specific points but be electrically connected over relatively wide areas, for example, similar areas to the shapes of the first to third connection electrodes CNE1, CNE2 and CNE3, respectively. For example, a surfaces area of the connection area may be increased, and thus the connection may be stably performed.

FIG. 7D illustrates a separator SPR, emission portions EP1, EP2 and EP3, a first electrode EL1, a conductive layer MCL, and a first power line PL1.

Referring to FIG. 7D, the first electrode EL1 may include a (1-1)-th electrode EL1_1 disposed in a first emission unit UT11 (or first row and first column emission unit), and a (1-2)-th electrode EL1_2 disposed in a second emission unit UT21 (or second row and first column emission unit). The (1-1)-th electrode EL1_1 may include first to third anodes AE1, AE2 and AE3, and the (1-2)-th electrode EL1_2 may include first to third anodes AE1a, AE2a and AE3a. The third anode AE3 may be divided into two to be spaced apart from each other in the second direction DR2. However, this is illustrated as an example, and the third anode AE3 may be provided as one pattern having a shape of one body like the first and second anodes AE1 and AE2. The content about the first to third anodes AE1, AE2 and AE3 and the content about the first to third anodes AE1a, AE2a and AE3a may be substantially the same. The first to third anodes AE1, AE2 and AE3 and the first to third anodes AE1a, AE2a and AE3a may be each referred to as a first sub-electrode.

The first to third anodes AE1, AE2 and AE3 may be provided as independent conductive patterns spaced apart from each other. For example, the first to third anodes AE1, AE2 and AE3 may be separated and electrically disconnected from each other by the separator SPR. The first to third anodes AE1, AE2 and AE3 may be disposed on positions overlapping the first to third emission portions EP1, EP2 and EP3, respectively. The first anode AE1 may have a shape corresponding to the first emission portion EP1, the second anode AE2 may have a shape corresponding to the second emission portion EP2, and the third anode AE3 may have a shape corresponding to the third emission portion EP3. The first to third anodes AE1, AE2 and AE3 may have larger surface areas than the first to third emission portions EP1, EP2 and EP3, respectively.

The conductive layer MCL may include a first conductive layer MCL1 disposed in the first emission unit UT11, and a second conductive layer MCL2 disposed in the second emission unit UT21. The first conductive layer MCL1 and the second conductive layer MCL2 may be disposed apart from each other in the second direction DR2. The first conductive layer MCL1 and the second conductive layer MCL2 may be electrically disconnected from each other. Although not illustrated, the conductive layer MCL may further include a third conductive layer disposed in a third emission unit UT12 (or first row and second column emission unit), and a fourth conductive layer disposed in a fourth emission unit UT22 (or second row and second column emission unit). The content about the first conductive layer MCL1 and the second conductive layer MCL2 may apply to the third conductive layer and the fourth conductive layer.

The first conductive layer MCL1 and the second conductive layer MCL2 may each include a metal layer or a transparent conductive layer. The metal layer may include molybdenum, silver, titanium, copper, aluminum, or an alloy thereof. The transparent conductive layer may include a transparent conductive oxide such as an indium tin oxide (ITO), an indium zinc oxide (IZO), a zinc oxide (ZnO), or an indium zinc tin oxide (IZTO). In another embodiment, the transparent conductive layer may include a conductive polymer such as poly(3,4-ethylenedioxythiophene) (PEDOT), metal nanowire, graphene, or the like.

The first conductive layer MCL1 and the second conductive layer MCL2 may each include metal layers having a multilayer structure. The metal layers may have, for example, a three-layer structure of titanium (Ti)/aluminum (Al)/titanium (Ti). In another embodiment, at least one of the metal layers having a multilayer structure may include at least one metal layer and at least one transparent conductive layer.

The first conductive layer MCL1 may overlap the (1-1)-th electrode EL1_1 in a plan view. For example, the first conductive layer MCL1 may overlap each of the first to third anodes AE1, AE2 and AE3 in a plan view. A surface area of the first conductive layer MCL1 may be greater than a surface area of the (1-1)-th electrode EL1_1. The first conductive layer MCL1 and each of the first to third anodes AE1, AE2 and AE3 may be disposed on different layers. The first conductive layer MCL1 may be electrically connected to each of the first to third anodes AE1, AE2 and AE3 through a first contact hole CNT1.

The second conductive layer MCL2 may overlap the (1-2)-th electrode EL1_2 in a plan view. For example, the second conductive layer MCL2 may overlap each of the first to third anodes AE1a, AE2a and AE3a in a plan view. A surface area of the second conductive layer MCL2 may be greater than a surface area of the (1-2)-th electrode EL1_2. The second conductive layer MCL2 and each of the first to third anodes AE1a, AE2a and AE3a may be disposed on different layers. The second conductive layer MCL2 may be electrically connected to each of the first to third anodes AE1a, AE2a and AE3a through a second contact hole CNT2.

The first contact hole CNT1 may be defined in a position overlapping each of the first to third anodes AE1, AE2 and AE3 in a plan view, and the second contact hole CNT2 may be defined in a position overlapping each of the first to third anodes AE1a, AE2a and AE3a in a plan view. The position in which the first contact hole CNT1 is defined is not limited to the illustrated embodiment, and the first contact hole CNT1 may be defined in a position overlapping the first to third anodes AE1, AE2 and AE3. The position in which the second contact hole CNT2 is defined is not limited to the illustrated embodiment, and the second contact hole CNT2 may be defined in a position overlapping the first to third anodes AE1a, AE2a and AE3a.

The first power line PL1 may include a (1-1)-th power line PL1-1 and a (1-2)-th power line PL1-2. The (1-1)-th power line PL1-1 may be electrically connected to the first conductive layer MCL1. For example, the (1-1)-th power line PL1-1 may extend from the first conductive layer MCL1. The (1-1)-th power line PL1-1 may be electrically connected to the (1-1)-th electrode EL1_1 through the first conductive layer MCL1. The (1-1)-th power line PL1-1 may apply the first voltage VDD1 (see FIG. 6) to the (1-1)-th electrode EL1_1 through the first conductive layer MCL1. For example, the (1-1)-th power line PL1-1 may apply the first voltage VDD1 to each of the first to third anodes AE1, AE2 and AE3, in common, through the first conductive layer MCL1.

The (1-2)-th power line PL1-2 may be electrically connected to the second conductive layer MCL2. For example, the (1-2)-th power line PL1-2 may extend from the second conductive layer MCL2. The (1-2)-th power line PL1-2 may be electrically connected to the (1-2)-th electrode EL1_2 through the second conductive layer MCL2. The (1-2)-th power line PL1-2 may apply the second voltage VDD2 (see FIG. 6) to the (1-2)-th electrode EL1_2 through the second conductive layer MCL2. For example, the (1-2)-th power line PL1-2 may apply the second voltage VDD2 to each of the first to third anodes AE1a, AE2a and AE3a, in common, through the second conductive layer MCL2.

The (1-1)-th power line PL1-1 and the (1-2)-th power line PL1-2 may not overlap each other in a plan view. The (1-1)-th power line PL1-1 may be disposed to overlap the separator SPR in a plan view. The (1-1)-th power line PL1-1 and the (1-2)-th power line PL1-2 may apply different voltages (e.g., the first voltage VDD1 and the second voltage VDD2 illustrated in FIG. 6) to pixels (e.g., the first pixel PX1 and the second pixel PX2 illustrated in FIG. 6), respectively. Although not illustrated, the first power line PL1 may further include a (1-3)-th power line which applies a third voltage to a third pixel, or the like.

Referring to FIGS. 4A, 6, and 7D together, a driving current ILD corresponding to the first voltage VDD1 may flow in a light emitting element LD included in the first pixel PX1, and the light emitting element LD may emit light having a luminance corresponding to the driving current ILD. A driving current ILD corresponding to the second voltage VDD2 may flow in a light emitting element LD included in the second pixel PX2, and the light emitting element LD may emit light having a luminance corresponding to the driving current ILD. For example, the first pixel PX1 and the second pixel PX2, which are different from each other, disposed in the display area DA may emit the light having different luminance levels independently of each other. As a result, pixels disposed in different areas of the display area DA may emit light having different luminance levels, thereby providing the display panel DP with improved display quality.

The first voltage VDD1 may be applied (or directly applied) to the first pixel PX1 through the (1-1)-th power line PL1-1, and the second voltage VDD2 may be applied (or directly applied) to the second pixel PX2 through the (1-2)-th power line PL1-2, thereby preventing a voltage drop (IR-DROP) phenomenon which occurs as a current path becomes long, and preventing the display quality of the display panel DP (see FIG. 2A) from deteriorating.

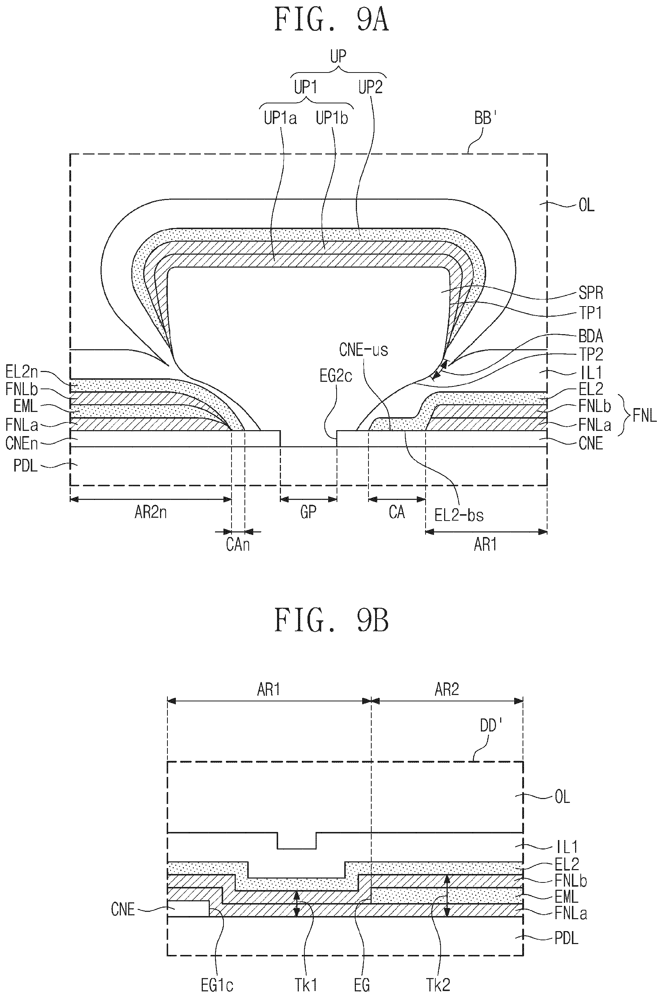

FIG. 8 is a schematic cross-sectional view of a display module according to an embodiment of the disclosure. FIGS. 9A and 9B are each an enlarged schematic cross-sectional view illustrating a partial area of a display panel according to an embodiment of the disclosure. FIG. 8 illustrates a schematic cross-sectional view of a portion corresponding to line I-I' in FIG. 7A. FIG. 9A illustrates an enlarged schematic cross-sectional view of area BB' in FIG. 8. FIG. 9B illustrates an enlarged schematic cross-sectional view of area DD' in FIG. 8. Embodiments will be described with reference to FIGS. 8 to 9B by denoting the same/similar components as/to those described above as the same/similar reference numbers or symbols and avoiding the content about the same/similar components, and mainly in terms of differences.

Referring to FIG. 8, a display module DM according to an embodiment of the disclosure may include a base layer BL, a circuit element layer DP-CL, a connection line CN, a connection electrode CNE, a display element layer DP-ED, an encapsulation layer ECL, and a sensing layer ISL. However, this is just an example, and the display module DM may not include the sensing layer ISL.

The circuit element layer DP-CL may include multiple insulating layers 10, 20, 30, 40, 50 and 60 sequentially disposed on the base layer BL, and multiple conductive patterns and semiconductor patterns disposed between the insulating layers 10, 20, 30, 40, 50 and 60. The conductive patterns and semiconductor patterns may be disposed between the insulating layers 10, 20, 30, 40, 50 and 60 and constitute a pixel driver PDC. For ease explanation, as an example, FIG. 8 illustrates a schematic cross-sectional view of one area of areas in which one emission portion is disposed.

The base layer BL may be a member that provides a base surface on which the pixel driver PDC is disposed. The base layer BL may be a rigid substrate, or a flexible substrate capable of being bent, folded, rolled, or the like. The base layer BL may be a glass substrate, a metal substrate, a polymer substrate, or the like. However, embodiments of the disclosure are not limited thereto, and the base layer BL may be an inorganic layer, an organic layer, or a composite material layer.

The base layer BL may have a multilayer structure. The base layer BL may include a first polymer resin layer, a silicon oxide (SiOₓ) layer disposed on the first polymer resin layer, an amorphous silicon (a-Si) layer disposed on the silicon oxide layer, and a second polymer resin layer disposed on the amorphous silicon layer. The silicon oxide layer and the amorphous silicon layer may be referred to as a base barrier layer.

The polymer resin layer may include a polyimide-based resin. The polymer resin layer may include at least one of an acrylate resin, a methacrylate resin, a polyisoprene-based resin, a vinyl-based resin, an epoxy-based resin, a urethane-based resin, a cellulose-based resin, a siloxane-based resin, a polyamide-based resin, or a perylene-based resin. The term "α-based" resin used herein indicates one including a functional group of "α".

Each of the insulating layers, conductive layers, and semiconductor layers, which are disposed on the base layer BL, may be formed through coating, deposition, and the like. Thereafter, through multiple photolithography processes, the insulating layer, the semiconductor layer, and the conductive layer may be selectively patterned to form a hole in the insulating layer, or a semiconductor pattern, a conductive pattern, signal lines, and the like may be formed.

The circuit element layer DP-CL may include first to sixth insulating layers 10, 20, 30, 40, 50 and 60 and the pixel driver PDC which are sequentially stacked on the base layer BL. As an example, FIG. 8 illustrates the pixel driver PDC illustrated in FIG. 4A, and the pixel driver PDC may include one transistor TR and two capacitors C1 and C2. The transistor TR may be one of multiple transistors included in the pixel driver PDC.

The transistor TR of the pixel driver PDC may correspond to a transistor electrically connected to a light emitting element LD through the connection line CN and the connection electrode CNE, i.e., a connection transistor electrically connected to a node (e.g., the fourth node N4 in FIG. 4A, the second node N2 in FIG. 4B, or the fourth node N4 in FIG. 4C) correspond to a cathode of the light emitting element LD, specifically to the sixth transistor T6 in FIG. 4A, the first transistor T1 in FIG. 4B, or the fourth transistor T4a in FIG. 4C. The transistor TR of the pixel driver PDC may be referred to as a connection transistor.

Although not illustrated, other transistors constituting the pixel driver PDC may each have the same structure as the transistor TR illustrated in FIG. 8. However, this is described as an example, and the other transistors constituting the pixel driver PDC may each have a different structure from the transistor TR illustrated in FIG. 8, and is not limited thereto.

The first insulating layer 10 may be disposed on the base layer BL. The first insulating layer 10 may be an inorganic layer and/or an organic layer, and have a single-layer or multilayer structure. The first insulating layer 10 may include at least one of an aluminum oxide, a titanium oxide, a silicon oxide, a silicon nitride, a silicon oxynitride, a zirconium oxide, or a hafnium oxide. The first insulating layer 10 may be illustrated a silicon oxide layer having a single-layer structure. Insulating layers to be described later may each be an inorganic layer and/or an organic layer, and have a single-layer or multilayer structure. The inorganic layer may include at least one of the foregoing materials, but is not limited thereto.

The first insulating layer 10 may cover a lower conductive layer BCL. For example, the display panel DP may further include the lower conductive layer BCL disposed to overlap the transistor TR. The lower conductive layer BCL may block an electrical potential due to a polarization phenomenon of the base layer BL from affecting the transistor TR. The lower conductive layer BCL may block light incident from a lower side into the transistor TR. At least one of an inorganic barrier layer or a buffer layer may be further disposed between the lower conductive layer BCL and the base layer BL.

The lower conductive layer BCL may include a reflective metal. For example, the lower conductive layer BCL may include titanium (Ti), molybdenum (Mo), a molybdenum-containing alloy, aluminum (Al), an aluminum-containing alloy, aluminum nitride (AlN), tungsten (W), tungsten nitride (WN), copper (Cu), and the like.

The lower conductive layer BCL may be electrically connected to a source of the transistor TR through a source electrode pattern S1. For example, the lower conductive layer BCL may be synchronized with the source of the transistor TR.

The transistor TR of the pixel driver PDC may be disposed on the first insulating layer 10. The transistor TR of the pixel driver PDC may include a semiconductor pattern SP and a gate electrode GE. The semiconductor pattern SP may be disposed on the first insulating layer 10. The semiconductor pattern SP may include an oxide semiconductor. For example, the oxide semiconductor may include a transparent conductive oxide (TCO) such as an indium tin oxide (ITO), an indium zinc oxide (IZO), an indium gallium zinc oxide (IGZO), a zinc oxide (ZnO) or an indium oxide (In₂O₃). However, embodiments of the disclosure are not limited thereto, and the semiconductor pattern SP may include amorphous silicon, low-temperature polycrystalline silicon, or polycrystalline silicon.

The semiconductor pattern SP may include a source region, a drain region, and a channel region that are divided according to a degree of conductivity. For example, the semiconductor pattern SP may include a source region SR, a drain region DR, and a channel region CR. The source region SR and the drain region DR may be spaced apart from each other with respect to the channel region CR therebetween. The channel region CR may be a portion overlapping the gate electrode GE in a plan view.

In a case in which the semiconductor pattern SP is an oxide semiconductor, the source region SR and the drain region DR may each be a reduced region. Accordingly, the source region SR and the drain region DR may each have a relatively higher reducible metal content than the channel region CR. In a case in which the semiconductor pattern SP is polycrystalline silicon, the source region SR and the drain region DR may each be a region doped at a high concentration.

The source region SR and the drain region DR may each have relatively higher conductivity than the channel region CR. The source region SR may correspond to a source electrode of the transistor TR, and the drain region DR may correspond to a drain electrode of the transistor TR. As illustrated in FIG. 8, separate source electrode pattern S1 and drain electrode pattern D1 which are electrically connected to the source region SR and the drain region DR, respectively, may be further provided. For example, each of the separate source electrode pattern S1 and drain electrode pattern D1 may be integrally formed with one of lines constituting the pixel driver PDC, and is not limited thereto.

The second insulating layer 20 may overlap, in common, multiple pixels and cover the semiconductor pattern SP. The second insulating layer 20 may each be an inorganic layer and/or an organic layer, and have a single-layer or multilayer structure. The second insulating layer 20 may include at least one of an aluminum oxide, a titanium oxide, a silicon oxide, a silicon nitride, a silicon oxynitride, a zirconium oxide, or a hafnium oxide. The second insulating layer 20 may be a silicon oxide layer having a single-layer structure.

The gate electrode GE may be disposed on the second insulating layer 20. The gate electrode GE may correspond to the gate of the transistor TR of the pixel driver PDC. The gate electrode GE may be disposed above the semiconductor pattern SP. However, this is illustrated as an example, and the gate electrode GE may be disposed below the semiconductor pattern SP and is not limited thereto.

The gate electrode GE may include titanium (Ti), silver (Ag), molybdenum (Mo), aluminum (Al), aluminum nitride (AlN), tungsten (W), tungsten nitride (WN), copper (Cu), or an alloy thereof, but is not particularly limited thereto.

The third insulating layer 30 may be disposed on the gate electrode GE. The third insulating layer 30 may be an inorganic layer and/or an organic layer, and have a single-layer or multilayer structure. The third insulating layer 30 may include at least one of an aluminum oxide, a titanium oxide, a silicon oxide, a silicon nitride, a silicon oxynitride, a zirconium oxide, or a hafnium oxide.

Among multiple conductive patterns S1, D1, CPE1, CPE2 and CPE3, a first capacitor electrode CPE1 and a second capacitor electrode CPE2 constitute a first capacitor C1. The first capacitor electrode CPE1 and the second capacitor electrode CPE2 may be spaced apart from each other with respect to the first insulating layer 10 and the second insulating layer 20 therebetween.

The first capacitor electrode CPE1 and the lower conductive layer BCL may have a shape of one body. The second capacitor electrode CPE2 and the gate electrode GE may be electrically connected to each other to have a shape of one body. However, this is just an example, and embodiments of the disclosure are not particularly limited thereto. For example, the first capacitor electrode CPE1 and the lower conductive layer BCL may be disposed on the same layer and spaced apart from each other. The second capacitor electrode CPE2 and the gate electrode GE may be disposed on the same layer and spaced apart from each other.

A third capacitor electrode CPE3 may be disposed on the third insulating layer 30. The third capacitor electrode CPE3 may be spaced apart from the second capacitor electrode CPE2 with respect to the third insulating layer 30 therebetween, and overlap the second capacitor electrode CPE2 in a plan view. The third capacitor electrode CPE3 may constitute a second capacitor C2 together with the second capacitor electrode CPE2.

The fourth insulating layer 40 may be disposed on the third insulating layer 30 and/or the third capacitor electrode CPE3. The fourth insulating layer 40 may be an inorganic layer and/or an organic layer, and have a single-layer or multilayer structure. The fourth insulating layer 40 may include at least one of an aluminum oxide, a titanium oxide, a silicon oxide, a silicon nitride, a silicon oxynitride, a zirconium oxide, or a hafnium oxide.

The source electrode pattern S1 and the drain electrode pattern D1 which are electrically connected to the semiconductor pattern SP may be disposed on the fourth insulating layer 40.

The source electrode pattern S1 may be electrically connected to the source region SR of the transistor TR through a first contact hole CNT1a, and the source electrode pattern S1 and the source region SR of the semiconductor pattern SP may function as a source of the transistor TR. The drain electrode pattern D1 may be electrically connected to the drain region DR of the transistor TR through a second contact hole CNT2a, and the drain electrode pattern D1 and the drain region DR of the semiconductor pattern SP may function as a drain of the transistor TR.

The fifth insulating layer 50 may be disposed on the source electrode pattern S1 and the drain electrode pattern D1.

The connection line CN may be disposed on the fifth insulating layer 50. The connection line CN may electrically connect the pixel driver PDC to the light emitting element LD together. For example, the connection line CN may electrically connect the transistor TR to the light emitting element LD together. The connection line CN may be a connection node through which the pixel driver PDC and the light emitting element LD are electrically connected to each other. For example, the connection line CN may correspond to the fourth node N4 illustrated in FIG. 4A.

A first conductive layer MCL1 and a (1-1)-th power line PL1-1 may be disposed on the fifth insulating layer 50. The first conductive layer MCL1 may be electrically connected to the light emitting element LD. The (1-1)-th power line PL1-1 may extend from the first conductive layer MCL1. The first conductive layer MCL1 and the (1-1)-th power line PL1-1 may be formed through the same process as the connection line CN.

The sixth insulating layer 60 may be disposed on the connection line CN. The sixth insulating layer 60 may be disposed on the fifth insulating layer 50 and cover at least a portion of the connection line CN. Each of the fifth insulating layer 50 and the sixth insulating layer 60 may be an organic layer. For example, each of the fifth insulating layer 50 and the sixth insulating layer 60 may include benzocyclobutene (BCB), polyimide, hexamethyldisiloxane (HMDSO), general purpose polymer such as polymethylmethacrylate (PMMA) or polystyrene (PS), polymer derivative having a phenol-based group, acrylate polymer, imide-based polymer, acryl ether-based polymer, amide-based polymer, fluorine-based polymer, p-xylene-based polymer, vinyl alcohol-based polymer, and a blend thereof, and the like.

A through-hole OP-60 which exposes at least a portion of the connection line CN may be provided in the sixth insulating layer 60. The connection line CN may be electrically connected to the connection electrode CNE through the portion exposed from the sixth insulating layer 60, and be electrically connected to the light emitting element LD. For example, the connection line CN together with the connection electrode CNE may electrically connect the transistor TR to the light emitting element LD together. In the display panel DP according to an embodiment of the disclosure, the sixth insulating layer 60 may be omitted or may be provided in plurality, and is not limited thereto. In a case in which the sixth insulating layer 60 is omitted, the connection line CN may also be omitted.

The connection line CN may include a first layer L1, a second layer L2, and a third layer L3 which are sequentially stacked in the third direction DR3. The second layer L2 may include a different material from the first layer L1. The second layer L2 may include a different material from the third layer L3. The second layer L2 may have a relatively larger thickness than the first layer L1. The second layer L2 may have a relatively larger thickness than the third layer L3. The second layer L2 may include a material having high conductivity. The second layer L2 may include aluminum (Al).

The first conductive layer MCL1 and the (1-1)-th power line PL1-1 may each include the same components as the connection line CN. For example, the first conductive layer MCL1 and the (1-1)-th power line PL1-1 may include a first layer L1a, a second layer L2a, and a third layer L3a which are sequentially stacked in the third direction DR3. However, embodiments are not limited thereto, and the first conductive layer MCL1 and the (1-1)-th power line PL1-1 may be formed through a separate process from a process for the connection line CN, and include a different structure from the connection line CN.

The first conductive layer MCL1 may be electrically connected to the light emitting element LD through a first contact hole CNT1. For example, the (1-1)-th power line PL1-1 may apply the first voltage VDD1 (see FIG. 6) to a first electrode EL1 of the light emitting element LD through the first conductive layer MCL1. The first electrode EL1 may correspond to the (1-1)-th electrode EL1_1 illustrated in FIG. 6.

The connection electrode CNE may be disposed on a pixel defining film PDL. The connection electrode CNE may electrically connect the pixel driver PDC to the light emitting element LD together. For example, the pixel driver PDC may be electrically connected to the light emitting element LD through the connection line CN and the connection electrode CNE. The connection electrode CNE may correspond to the third connection electrode CNE3 illustrated in FIG. 7A. Each of the second connection electrode CNE2 (see FIG. 7A) and the third connection electrode CNE3 (see FIG. 7A) may also have a similar structure to the connection electrode CNE.

The connection electrode CNE may include a first edge EG1c adjacent to an emission opening portion OP-PDL, and a second edge EG2c surrounding the first edge EG1c. A second electrode EL2 of the light emitting element LD may be in contact with the connection electrode CNE on an area adjacent to the second edge EG2c.

The connection electrode CNE may include a transparent conductive oxide (TCO) such as an indium tin oxide (ITO), an indium zinc oxide (IZO), an indium gallium zinc oxide (IGZO), a zinc oxide (ZnO) or an indium oxide (In₂O₃). However, the material constituting the connection electrode CNE is not limited to the foregoing examples.

The display element layer DP-ED may be disposed on the circuit element layer DP-CL. The display element layer DP-ED may include the pixel defining film PDL, the light emitting element LD, and a separator SPR.

A through-hole OP-P may be defined in the pixel defining film PDL. The through-hole OP-P may be provided in plurality to be disposed to correspond (or to overlap) to each of light emitting elements. A size of the through-hole OP-P defined in the pixel defining film PDL may be greater than a size of the through-hole OP-60 defined in the sixth insulating layer 60. The connection electrode CNE may be disposed in the through-hole OP-P and the through-hole OP-60, and electrically connected to the connection line CN.

The emission opening portion OP-PDL spaced apart from the through-hole OP-P may be defined in the pixel defining film PDL. The emission opening portion OP-PDL may be provided in plurality to be disposed to correspond (or to overlap) to each of the light emitting elements. The emission opening portion OP-PDL may expose at least a portion of the first electrode EL1. Some components (e.g., an emission layer EML) of the light emitting element LD may be disposed in the emission opening portion OP-PDL.

The light emitting element LD may include the first electrode EL1, an intermediate layer IML, and the second electrode EL2. The intermediate layer IML may include the emission layer EML and a functional layer FNL.

The first electrode EL1 may be a semi-transmissive, transmissive, or reflective electrode. According to an embodiment of the disclosure, the first electrode EL1 may include a reflective layer made of silver (Ag), magnesium (Mg), aluminum (Al), platinum (Pt), palladium (Pd), gold (Au), nickel (Ni), neodymium (Nd), iridium (Ir), chromium (Cr), or a compound thereof, or the like, and a transparent or semi-transparent electrode layer provided on the reflective layer. The transparent or semi-transparent electrode layer may include at least one selected from the group consisting of an indium tin oxide (ITO), an indium zinc oxide (IZO), an indium gallium zinc oxide (IGZO), a zinc oxide (ZnO) or an indium oxide (In₂O₃), and an aluminum-doped zinc oxide (AZO). For example, the first electrode EL1 may include a stack structure of ITO/Ag/ITO.

The first electrode EL1 may be an anode of the light emitting element LD disposed on the sixth insulating layer 60. For example, the first electrode EL1 may be electrically connected to the first conductive layer MCL1 through the first contact hole CNT1 defined to pass through the sixth insulating layer 60. The (1-1)-th power line PL1-1 may apply the first voltage VDD1 (see FIG. 6) to the first electrode EL1 of the light emitting element LD through the first conductive layer MCL1. For example, first voltages corresponding to multiple light emitting elements may be applied to multiple light emitting elements, respectively.

The functional layer FNL may include a first intermediate functional layer FNLa disposed between the first electrode EL1 and the emission layer EML, and a second intermediate functional layer FNLb disposed between the second electrode EL2 and the emission layer EML. In an embodiment of the disclosure, one of the first intermediate functional layer FNLa and the second intermediate functional layer FNLb may be omitted. The emission layer EML is illustrated as being inserted into the functional layer FNL. For example, the emission layer EML may be understood as being disposed between the first intermediate functional layer FNLa and the second intermediate functional layer FNLb.

The functional layer FNL may control movement of charges between the first electrode EL1 and the second electrode EL2. For example, the first intermediate functional layer FNLa may include a hole injection/transport material and/or an electron injection/transport material. The second intermediate functional layer FNLb may include at least one of an electron blocking layer, a hole transport layer, a hole injection layer, a hole blocking layer, an electron transport layer, an electron injection layer, or a charge generation layer.

Referring to FIGS. 8 and 9A, the separator SPR may be disposed on the pixel defining film PDL. The separator SPR may be disposed on a gap GP between the connection electrode CNE and a connection electrode CNEn adjacent to the connection electrode CNE, which are disposed on the pixel defining film PDL.

The second electrode EL2 and the intermediate layer IML may be formed by being deposited, in common, on multiple pixels through an open mask. Here, each of the second electrode EL2 and the intermediate layer IML may be divided by the separator SPR. As described above, the separator SPR may have a shape of a closed line with respect to each of the emission portions and accordingly, the second electrode EL2 and the intermediate layer IML may each have a shape divided for each of the emission portions. For example, the second electrode EL2 and the intermediate layer IML may be electrically independent for each of adjacent pixels. However, this is described as an example. The functional layer FNL of the intermediate layer IML may be formed through an open mask, and the emission layer EML may be formed through a fine metal mask, and embodiments of the disclosure are not limited thereto.

Referring to FIG. 9A, the separator SPR may have a dual reverse tapered shape. For example, a taper angle of a first side surface TP1 of the separator SPR and a taper angle of a second side surface TP2 of the separator SPR, each of which is formed with respect to a top surface of the pixel defining film PDL, may be different from each other. The taper angles may be obtuse angles. For example, referring to FIG. 9A, the taper angle of the first side surface TP1 formed with respect to the top surface of the pixel defining film PDL may be less than the taper angle of the second side surface TP2 formed with respect to the top surface of the pixel defining film PDL.

In an embodiment of the disclosure, a connection region BDA between the first side surface TP1 and the second side surface TP2 may have a curve on a cross-section. For example, the connection region BDA between the first side surface TP1 and the second side surface TP2, which have different taper angles, may have a round shape having a gradually varying tilt.

In an embodiment of the disclosure, as the second side surface TP2 has the taper angle greater than that of the first side surface TP1, a predetermined space may be defined between the second side surface TP2 of the separator SPR and the connection electrode CNEn. A second electrode EL2n may have a shape extending toward the predetermined space.

However, the shape of the separator SPR illustrated in FIG. 9A is just an example, and the taper angles may be variously set as long as the separator SPR electrically disconnects the second electrode EL2 for each pixel. The separator SPR may have a structure like a tip portion, and is not limited thereto.

The separator SPR may include a material having an insulating property, and particularly, may include an organic insulating material. The separator SPR may include an inorganic insulating material or have a multilayer structure of an organic insulating material and an inorganic insulating material, and may include a conductive material according to an embodiment. For example, the type of the material of the separator SPR is not particularly limited as long as the separator SPR electrically disconnects the second electrode EL2 for each pixel.

A dummy layer UP may be disposed on the separator SPR. The dummy layer UP may include a first dummy layer UP1 disposed on the separator SPR, and a second dummy layer UP2 disposed on the first dummy layer UP1. The first dummy layer UP1 may be formed through the same process and include the same material as the intermediate layer IML. The first dummy layer UP1 may include a (1-1)-th dummy layer UP1a and a (1-2)-th dummy layer UP1b. The (1-1)-th dummy layer UP1a may be formed through the same process and include the same material as the first intermediate functional layer FNLa. The (1-2)-th dummy layer UP1b may be formed through the same process and include the same material as the second intermediate functional layer FNLb. The second dummy layer UP2 may be formed through the same process and include the same material as the second electrode EL2. For example, the first dummy layer UP1 and the second dummy layer UP2 may be formed at the same time during the processes of forming the functional layer FNL and the second electrode EL2, respectively. In another embodiment, the display panel DP may not include the dummy layer UP.

Referring to FIGS. 8 and 9B together, the intermediate layer IML may include a first area AR1 and a second area AR2. For example, the first area AR1 may be an area including only layers, which are formed by the open mask, of layers constituting the intermediate layer IML, and the second area AR2 may be an area including all of layers, which are formed by the open mask and the fine metal mask, of the layers constituting the intermediate layer IML.

For example, the first area AR1 may include the first intermediate functional layer FNLa and the second intermediate functional layer FNLb. The second area AR2 may include the first intermediate functional layer FNLa, the second intermediate functional layer FNLb, and the emission layer EML. Thus, a first thickness TK1 of the first area AR1 of the intermediate layer IML may be less than a second thickness TK2 of the second area AR2 of the intermediate layer IML in the third direction DR3. A portion of a boundary between the first area AR1 and the second area AR2 may not overlap the connection electrode CNE and be spaced apart from the first edge EG1c of the connection electrode CNE. Thus, an edge EG of the emission layer EML included only in the second area AR2 may be spaced apart from the first edge EG1c.

Referring back to FIG. 9A, the first area AR1 of the intermediate layer IML is illustrated at a right side on the basis of the separator SPR, and a second area AR2n of an adjacent intermediate layer is illustrated at a left side on the basis of the separator SPR. Comparison between the left and the right of the separator SPR may confirm that a surface area of an area, from which the connection electrode CNE is exposed, of a portion adjacent to the first area AR1 is greater than a surface area of an area, from which the connection electrode CNEn is exposed, of a portion adjacent to the second area AR2n.

The second electrode EL2 may be in contact with the connection electrode CNE through a connection area CA. The second electrode EL2n may be in contact with the connection electrode CNEn through a connection area CAn. For example, the layer formed by the fine metal mask, for example, the emission layer EML, may be formed not to overlap a portion of the connection electrode CNE, thereby stably securing the exposed area in the portion of the connection electrode CNE, and improving reliability of contact between the connection electrode CNE and the second electrode EL2. Thus, spot defects caused by contact defects may be reduced or removed. As a result, the display panel DP and the display device DD (see FIG. 2A) including the same may be improved in image quality or manufacturing yield.

According to an embodiment of the disclosure, the connection electrode CNE has a shape which surrounds at least a portion of the emission portion EP1 (FIG. 4A) defined in the light emitting element LD. Thus, a degree of freedom of the position at which the connection electrode CNE and the light emitting element LD are electrically connected, and a degree of freedom of the position at which the connection electrode CNE and the pixel driver PDC are electrically connected may be improved. A top surface CNE-us of the connection electrode CNE may be in contact with a bottom surface EL2-bs of the second electrode EL2 of the light emitting element LD. For example, the reliability of the contact between the connection electrode CNE and the second electrode EL2 may be improved. Moreover, since a bottom surface of the connection electrode CNE and a top surface of the connection line CN are contact with each other, the reliability of the contact may be improved. Thus, the size of each of the through-holes OP-P and OP-60 for connecting the connection electrode CNE and the connection line CN may be reduced or minimized. Accordingly, a surface area or resolution of the emission portion of the display panel DP may be easily increased.

The encapsulating layer ECL may be disposed on the display element layer DP-ED. The encapsulating layer ECL may cover the light emitting element LD and cover the separator SPR. The encapsulating layer ECL may include a first inorganic layer IL1, an organic layer OL, and a second inorganic layer IL2 that are sequentially stacked. However, embodiments of the disclosure are not limited thereto, and the encapsulation layer ECL may further include multiple inorganic layers and organic layers. In another embodiment, the encapsulation layer ECL may be a glass substrate.

The first and second inorganic layers IL1 and IL2 may protect the light emitting element LD from moisture and oxygen outside the display panel DP, and the organic layer OL may protect the light emitting element LD from foreign substances such as particles remaining during forming of the second inorganic layer IL2. The first and second inorganic layers IL1 and IL2 may each include a silicon nitride layer, a silicon oxynitride layer, a silicon oxide layer, a titanium oxide layer, an aluminum oxide layer, or the like. The organic layer OL may include an acrylic organic layer, and the type of the material is not limited to thereto.

The sensing layer ISL may detect an external input. The sensing layer ISL may be formed on the encapsulation layer ECL through a continuous process. Here, the sensing layer ISL may be expressed as being disposed (e.g., directly disposed) on the encapsulation layer ECL. The expression "being disposed directly" may mean that another component is not disposed between the sensing layer ISL and the encapsulation layer ECL. For example, a separate adhesive member may not be disposed between the sensing layer ISL and the encapsulation layer ECL. However, this is illustrated as an example. In the display panel DP according to an embodiment of the disclosure, the sensing layer ISL may be separately formed and then coupled to the display panel DP through an adhesive member, and is not limited thereto.

The sensing layer ISL may include multiple conductive layers and multiple insulating layers. Multiple conductive layers may include a first sensing conductive layer MTL1 and a second sensing conductive layer MTL2, and multiple insulating layers may include first to third sensing insulating layers 71, 72 and 73. However, this is illustrated as an example, and the number of the conductive layers and the number of the insulating layers are not limited thereto.

Each of the first to third sensing insulating layers 71, 72 and 73 may have a single-layer structure or a multilayer structure in which layers are stacked in the third direction DR3. The first to third sensing insulating layers 71, 72 and 73 may include an inorganic film. The inorganic film may include at least one of an aluminum oxide, a titanium oxide, a silicon oxide, a silicon nitride, a silicon oxynitride, a zirconium oxide, or a hafnium oxide. The first to third sensing insulating layers 71, 72 and 73 may include an organic film. The organic film may include at least one of acrylate resin, a methacrylate resin, polyisoprene, a vinyl-based resin, an epoxy-based resin, a urethane-based resin, a cellulose-based resin, a siloxane-based resin, a polyimide-based resin, a polyamide-based resin, or a perylene-based resin.

The first sensing conductive layer MTL1 may be disposed between the first sensing insulating layer 71 and the second sensing insulating layer 72, and the second sensing conductive layer MTL2 may be disposed between the second sensing insulating layer 72 and the third sensing insulating layer 73. A portion of the second sensing conductive layer MTL2 may be electrically connected to the first sensing conductive layer MTL1 through a contact hole CNT defined in the second sensing insulating layer 72. Each of the first sensing conductive layer MTL1 and the second sensing conductive layer MTL2 may have a single-layer structure or a multilayer structure in which layers are stacked in the third direction DR3.

The sensing conductive layer having a single-layer structure may include a metal layer or a transparent conductive layer. The metal layer may include molybdenum, silver, titanium, copper, aluminum, or an alloy thereof. The transparent conductive layer may include a transparent conductive oxide such as an indium tin oxide (ITO), an indium zinc oxide (IZO), a zinc oxide (ZnO), or an indium zinc tin oxide (IZTO). In another embodiment, the transparent conductive layer may include a conductive polymer such as PEDOT, metal nanowire, graphene, or the like.

The sensing conductive layer having a multilayer structure may include metal layers. The metal layers may have, for example, a three-layer structure of titanium (Ti)/aluminum (Al)/titanium (Ti). In another embodiment, the sensing conductive layer having a multilayer structure may include at least one metal layer and at least one transparent conductive layer.

The first sensing conductive layer MTL1 and the second sensing conductive layer MTL2 may constitute a sensor that detects an external input in the sensing layer ISL. The sensor may be driven by a capacitance method, and may be driven by any one of a mutual capacitance method or a self-capacitance method. However, this is described as an example. The sensor may be driven by a resistive method, an ultrasonic method, or an infrared method, in addition to the capacitance method, and is not limited thereto.

Each of the first sensing conductive layer MTL1 and the second sensing conductive layer MTL2 may include a transparent conductive oxide, and may have a metal mesh shape made of an opaque conductive material. In case that visibility of an image displayed by the display panel DP is not reduced, each of the first sensing conductive layer MTL1 and the second sensing conductive layer MTL2 may have various materials and various shapes, and is not limited thereto.

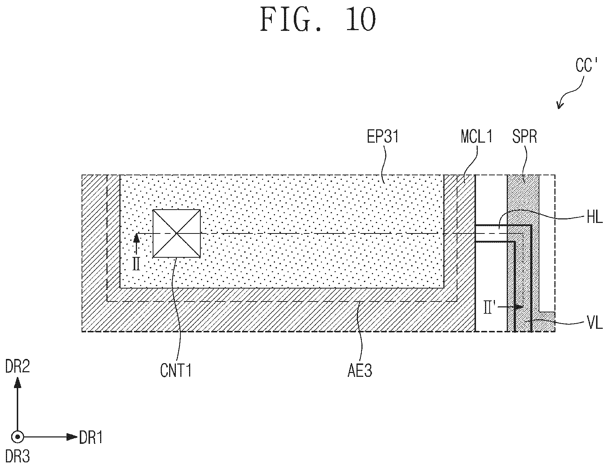

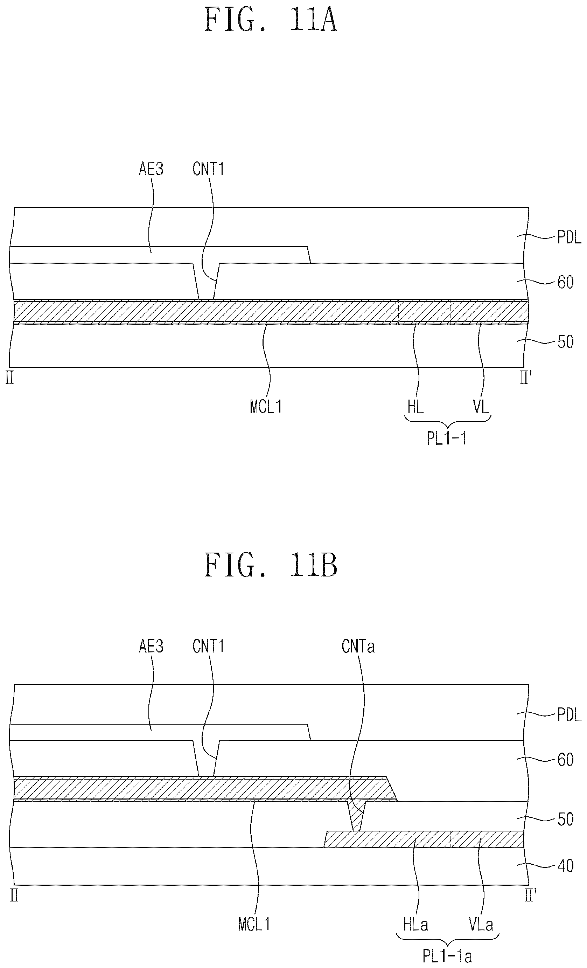

FIG. 10 is an enlarged schematic view of area CC' illustrated in FIG. 7D. FIG. 11A is a schematic cross-sectional view of a display panel corresponding to line II-II' illustrated in FIG. 10 according to an embodiment of the disclosure. FIGS. 11B to 11D are each a schematic cross-sectional view of a display panel corresponding to line II-II' illustrated in FIG. 10 according to an embodiment of the disclosure. FIGS. 11A to 11D illustrate only some components of a display panel DP.

Referring to FIGS. 10 and 11A, a (1-1)-th power line PL1-1 may include a horizontal line HL extending in the first direction DR1, and a vertical line VL extending in the second direction DR2. The horizontal line HL may be disposed on the same layer as a first conductive layer MCL1 and extend from the first conductive layer MCL1. The vertical line VL may be disposed on the same layer as the horizontal line HL and extend from the horizontal line HL. For example, the first conductive layer MCL1, the horizontal line HL, and the vertical line VL may be disposed on a fifth insulating layer 50. The vertical line VL may not overlap the first electrode EL1 in a plan view. The vertical line VL may overlap a separator SPR in a plan view. Although not illustrated, the (1-2)-th power line PL1-2 (see FIG. 7D) may also include a horizontal line extending in the first direction DR1, and a vertical line extending in the second direction DR2.

Referring to FIGS. 10 and 11B, a (1-1)-th power line PL1-1a and a first conductive layer MCL1 may be disposed on different layers. For example, the (1-1)-th power line PL1-1a may be disposed on a fourth insulating layer 40. The (1-1)-th power line PL1-1a may be disposed on the same layer and formed through the same process as the source electrode pattern S1 and the drain electrode pattern D1 illustrated in FIG. 8. The (1-1)-th power line PL1-1a may be electrically connected to the first conductive layer MCL1 through a contact hole CNTa defined in a fifth insulating layer 50. The (1-1)-th power line PL1-1a may partially overlap the first conductive layer MCL1 in a plan view. The contact hole CNTa defined in the fifth insulating layer 50 may be defined in an area overlapping the (1-1)-th power line PL1-1a and the first conductive layer MCL1 in a plan view.

The (1-1)-th power line PL1-1a may include a horizontal line HLa extending in the first direction DR1, and a vertical line VLa extending in the second direction DR2. The vertical line VLa may be disposed on the same layer as the horizontal line HLa and extend from the horizontal line HLa.

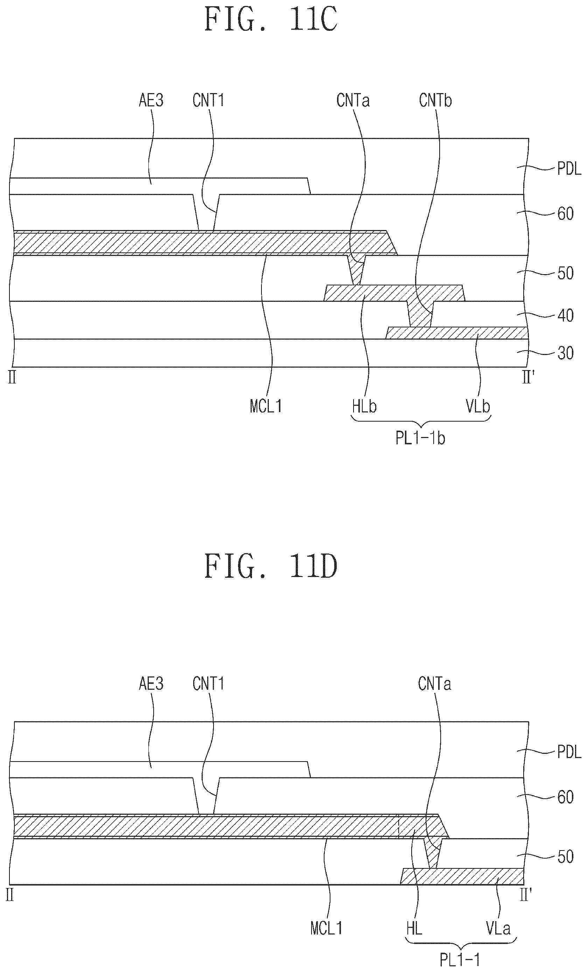

Referring to FIGS. 10 and 11C, a (1-1)-th power line PL1-1b may include a horizontal line HLb extending in the first direction DR1, and a vertical line VLb extending in the second direction DR2. According to an embodiment of the disclosure, the vertical line VLb and the horizontal line HLb may be disposed on different layers. For example, the horizontal line HLb may be disposed on a fourth insulating layer 40, and the vertical line VLb may be disposed on a third insulating layer 30. The vertical line VLb may be disposed on the same layer and formed through the same process as the third capacitor electrode CPE3 illustrated in FIG. 8.

The vertical line VLb may be electrically connected to the horizontal line HLb through a contact hole CNTb defined in the fourth insulating layer 40. The vertical line VLb may partially overlap the horizontal line HLb in a plan view. The contact hole CNTb defined in the fourth insulating layer 40 may be defined in an area overlapping the horizontal line HLb and the vertical line VLb in a plan view.

Referring to FIGS. 10 and 11D, a (1-1)-th power line PL1-1 may include a horizontal line HL extending in the first direction DR1, and a vertical line VLa extending in the second direction DR2. According to an embodiment of the disclosure, the vertical line VLa and the horizontal line HL may be disposed on different layers. The horizontal line HL may be disposed on the same layer as a first conductive layer MCL1 and extend from the first conductive layer MCL1. The vertical line VLa may be disposed on a fourth insulating layer 40. The vertical line VLa may be disposed on the same layer and formed through the same process as the source electrode pattern S1 and the drain electrode pattern D1 illustrated in FIG. 8.

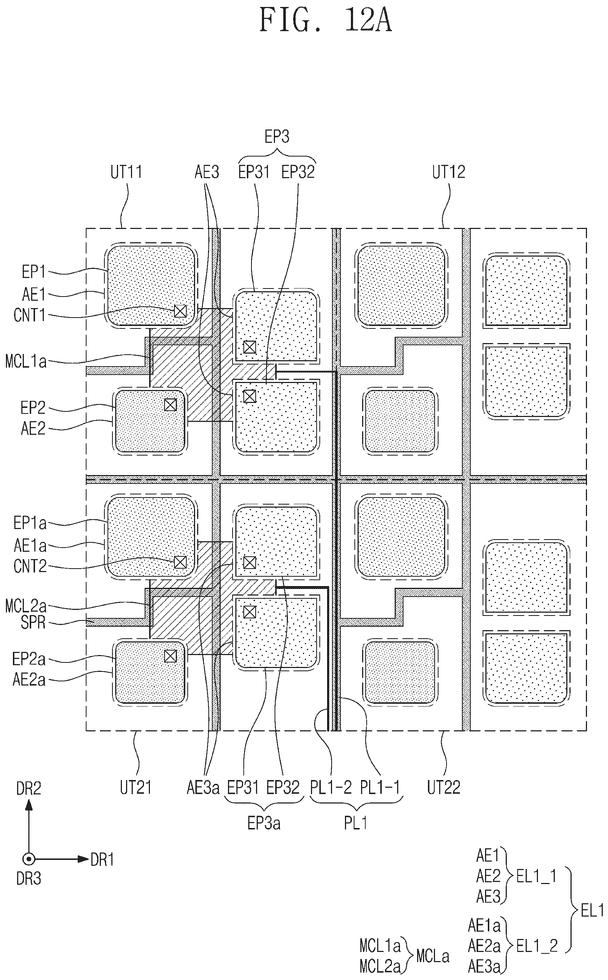

The vertical line VLa may be electrically connected to the horizontal line HL through a contact hole CNTa defined in a fifth insulating layer 50. The vertical line VLa may partially overlap the horizontal line HL in a plan view. The contact hole CNTa defined in the fifth insulating layer 50 may be defined in an area overlapping the horizontal line HL and the vertical line VLa in a plan view. FIGS. 12A to 12E are each an enlarged schematic plan view of a partial area of a display panel according to an embodiment of the disclosure. Hereinafter, embodiments will be described by denoting the same/similar components as/to those described above as the same/similar reference numbers or symbols and avoiding the content about the same/similar components, and mainly in terms of differences.

Referring to FIG. 12A, a conductive layer MCLa may include a first conductive layer MCL1a disposed in a first emission unit UT11, and a second conductive layer MCL2a disposed in a second emission unit UT21. The first conductive layer MCL1a and the second conductive layer MCL2a may be disposed apart from each other in the second direction DR2. The first conductive layer MCL1a and the second conductive layer MCL2a may be electrically disconnected from each other. Although not illustrated, the conductive layer MCLa may further include a third conductive layer disposed in a third emission unit UT12 (or first row and second column emission unit), and a fourth conductive layer disposed in a fourth emission unit UT22 (or second row and second column emission unit). The contents about the first conductive layer MCL1a and the second conductive layer MCL2a may apply to the third conductive layer and the fourth conductive layer.

According to an embodiment of the disclosure, the first conductive layer MCL1a may overlap a portion of each of first to third anodes AE1, AE2 and AE3 (or first sub-electrodes) in a plan view. The first to third anodes AE1, AE2 and AE3 may each be electrically connected to the first conductive layer MCL1a through a first contact hole CNT1. The first to third anodes AE1, AE2 and AE3 may receive, in common, the first voltage VDD1 (see FIG. 6) through the first conductive layer MCL1a. The first contact hole CNT1 may be defined in a position overlapping the first conductive layer MCL1a and each of the first to third anodes AE1, AE2 and AE3 in a plan view.

According to an embodiment of the disclosure, the second conductive layer MCL2a may overlap a portion of each of first to third anodes AE1a, AE2a and AE3a (or first sub-electrodes) in a plan view. The first to third anodes AE1a, AE2a and AE3a may each be electrically connected to the second conductive layer MCL2a through a second contact hole CNT2. The first to third anodes AE1a, AE2a and AE3a may receive, in common, the second voltage VDD2 (see FIG. 6) through the second conductive layer MCL2a. The second contact hole CNT2 may be defined in a position overlapping the second conductive layer MCL2a and each of the first to third anodes AE1a, AE2a and AE3a in a plan view.

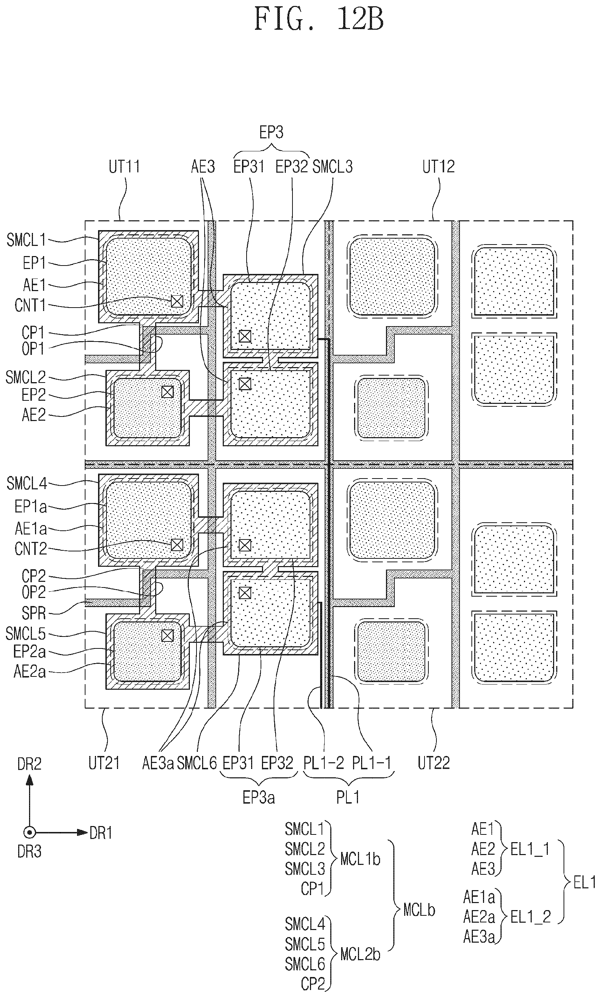

Referring to FIG. 12B, a conductive layer MCLb may include a first conductive layer MCL1b disposed in a first emission unit UT11, and a second conductive layer MCL2b disposed in a second emission unit UT21. The first conductive layer MCL1b and the second conductive layer MCL2b may be disposed apart from each other in the second direction DR2. The first conductive layer MCL1b and the second conductive layer MCL2b may each have a mesh shape.

According to an embodiment of the disclosure, the first conductive layer MCL1b may include first to third sub-conductive layers SMCL1, SMCL2 and SMCL3, and a first connection pattern CP1 that electrically connects the first to third sub-conductive layers SMCL1, SMCL2 and SMCL3 together. The first to third sub-conductive layers SMCL1, SMCL2 and SMCL3 may have shapes corresponding to shapes of first to third anodes AE1, AE2 and AE3, respectively. However, embodiments of the disclosure are not limited thereto, and the first to third sub-conductive layers SMCL1, SMCL2 and SMCL3 may have different shapes from the first to third anodes AE1, AE2 and AE3, respectively. A first opening portion OP1 defined by the first to third sub-conductive layers SMCL1, SMCL2 and SMCL3 and the first connection pattern CP1 may be defined in the first conductive layer MCL1b. However, according to an embodiment of the disclosure, the first opening portion OP1 may not be defined in the first conductive layer MCL1b.

According to an embodiment of the disclosure, the second conductive layer MCL2b may include fourth to sixth sub-conductive layers SMCL4, SMCL5 and SMCL6, and a second connection pattern CP2 that electrically connects the fourth to sixth sub-conductive layers SMCL4, SMCL5 and SMCL6 together. The fourth to sixth sub-conductive layers SMCL4, SMCL5 and SMCL6 may have shapes corresponding to shapes of first to third anodes AE1a, AE2a and AE3a, respectively. However, embodiments of the disclosure are not limited thereto, and the fourth to sixth sub-conductive layers SMCL4, SMCL5 and SMCL6 may have different shapes from the first to third anodes AE1a, AE2a and AE3a, respectively. A second opening portion OP2 defined by the fourth to sixth sub-conductive layers SMCL4, SMCL5 and SMCL6 and the second connection pattern CP2 may be defined in the second conductive layer MCL2b. However, according to an embodiment of the disclosure, the second opening portion OP2 may not be defined in the second conductive layer MCL2b.

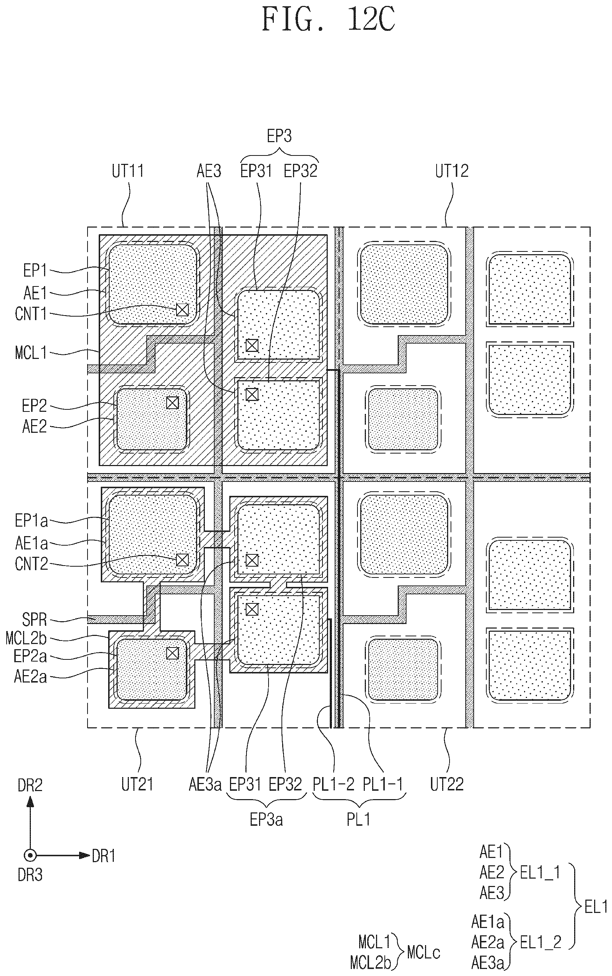

Referring to FIG. 12C, a conductive layer MCLc may include a first conductive layer MCL1 disposed in a first emission unit UT11, and a second conductive layer MCL2b disposed in a second emission unit UT21. According to an embodiment of the disclosure, a shape of the first conductive layer MCL1 and a shape of the second conductive layer MCL2b may be different from each other. For example, the shape of the first conductive layer MCL1 may be the same as the shape of the first conductive layer MCL1 illustrated in FIG. 7D, and the shape of the second conductive layer MCL2b may be the same as the shape of the second conductive layer MCL2b illustrated in FIG. 12B. The shapes of the conductive layers MCL1 and MCL2b are not limited to the illustrated embodiment. For example, the shapes of the conductive layers disposed in the emission units, respectively, may be different.

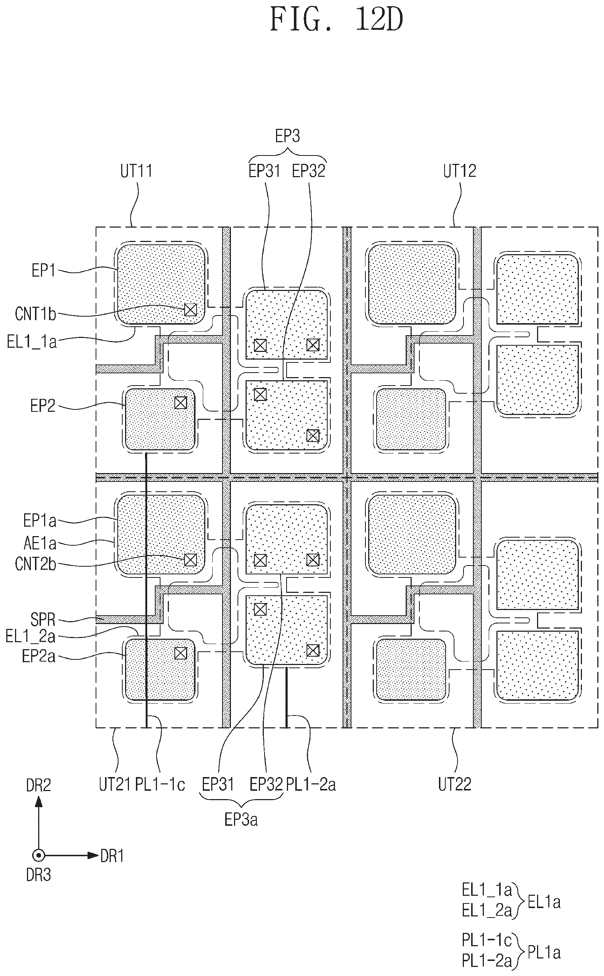

Referring to FIG. 12D, a first electrode ELla may include a (1-1)-th electrode EL1_1a disposed in a first emission unit UT11, and a (1-2)-th electrode EL1_2a disposed in a second emission unit UT21. The (1-1)-th electrode EL1_1a and the (1-2)-th electrode EL1_2a may be disposed apart from each other with respect to a separator SPR therebetween in the second direction DR2. The (1-1)-th electrode EL1_1a and the (1-2)-th electrode EL1_2a may each have a mesh shape.

The (1-1)-th electrode EL1_1a may be provided, in common, to first to third emission portions EP1, EP2 and EP3. The (1-1)-th electrode EL1_1a may be provided as one layer that is one body, and may be disposed non-overlapping the separator SPR. An opening portion may be defined in the (1-1)-th electrode EL1_1a according to an embodiment of the disclosure, and the opening portion may pass through the (1-1)-th electrode EL1_1a. The opening portion may not overlap the first to third emission portions EP1, EP2 and EP3.

The (1-2)-th electrode EL1_2a may be provided, in common, to first to third emission portions EP1a, EP2a and EP3a. The (1-2)-th electrode EL1_2a may be provided as one layer that is one body, and may be disposed non-overlapping the separator SPR. An opening portion may be defined in the (1-2)-th electrode EL1_2a according to an embodiment of the disclosure, and the opening portion may pass through the (1-2)-th electrode EL1_2a. The opening portion may not overlap the first to third emission portions EP1a, EP2a and EP3a. According to an embodiment of the disclosure, the (1-1)-th power line PL1-1c may overlap the (1-2)-th electrode EL1_2a, that is, the (1-1)-th power line PL1-1c may overlap the pixels.

A first power line PL1a may include a (1-1)-th power line PL1-1c and a (1-2)-th power line PL1-2a. The (1-1)-th power line PL1-1c may be electrically connected to the (1-1)-th electrode EL1_1a. For example, the (1-1)-th power line PL1-1c may extend from the (1-1)-th electrode EL1_1a. According to an embodiment of the disclosure, the (1-1)-th power line PL1-1c and the (1-1)-th electrode EL1_1a may be disposed on different layers. The (1-1)-th power line PL1-1c may be electrically connected to the (1-1)-th electrode EL1_1a through a first contact hole CNT1b. The (1-1)-th power line PL1-1c may directly apply the first voltage VDD1 (see FIG. 6) to the (1-1)-th electrode EL1_1a.

The (1-2)-th power line PL1-2a may be electrically connected to the (1-2)-th electrode EL1_2a. For example, the (1-2)-th power line PL1-2a may extend from the (1-2)-th electrode EL1_2a. According to an embodiment of the disclosure. the (1-2)-th power line PL1-2a and the (1-2)-th electrode EL1_2a may be disposed on different layers. The (1-2)-th power line PL1-2a may be electrically connected to the (1-2)-th electrode EL1_2a through a second contact hole CNT2b. The (1-2)-th power line PL1-2a may directly apply the second voltage VDD2 (see FIG. 6) to the (1-2)-th electrode EL1_2a.

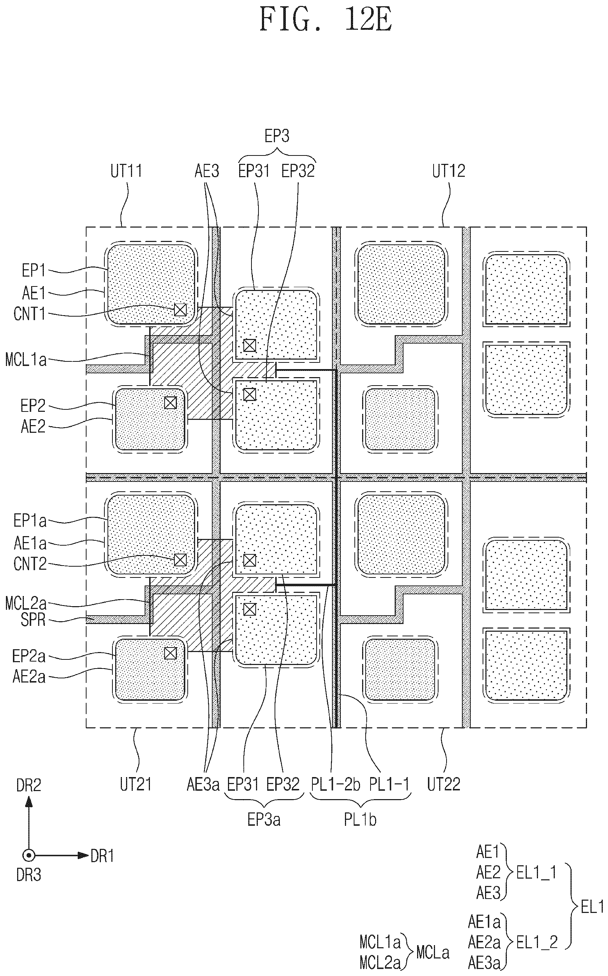

Referring to FIG. 12E, a first power line PL1b may include a (1-1)-th power line PL1-1 and a (1-2)-th power line PL1-2b. According to an embodiment of the disclosure, a portion of the (1-1)-th power line PL1-1 and a portion of the (1-2)-th power line PL1-2b may overlap each other in a plan view. For example, a portion (e.g., a first vertical line), which extends in the second direction DR2, of the (1-1)-th power line PL1-1 and a portion (e.g., a second vertical line), which extends in the second direction DR2, of the (1-2)-th power line PL1-2b may overlap each other in a plan view. The first vertical line and the second vertical line may overlap a separator SPR in a plan view.

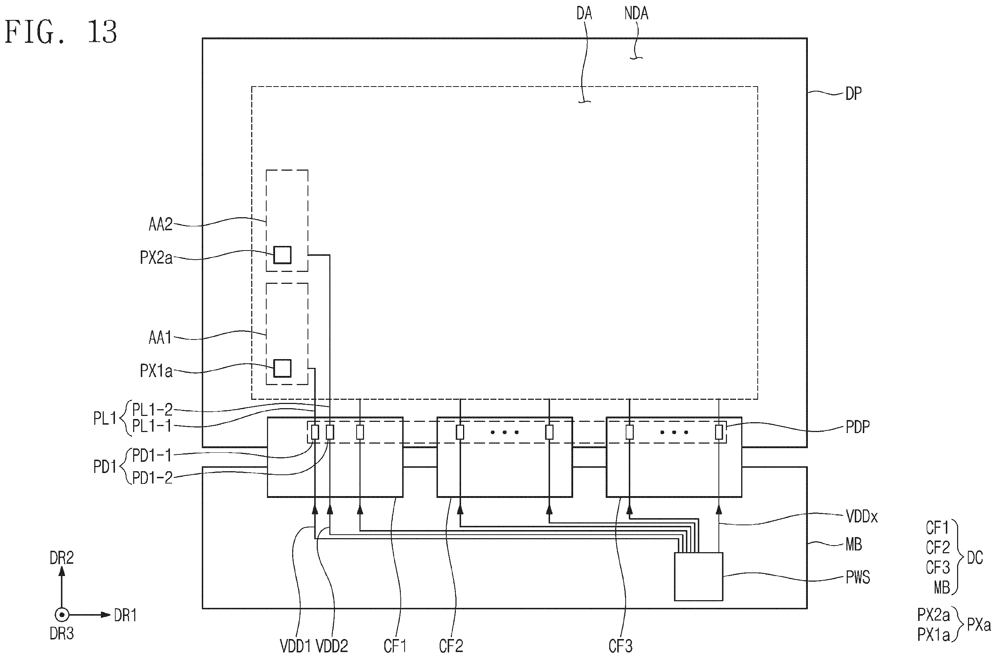

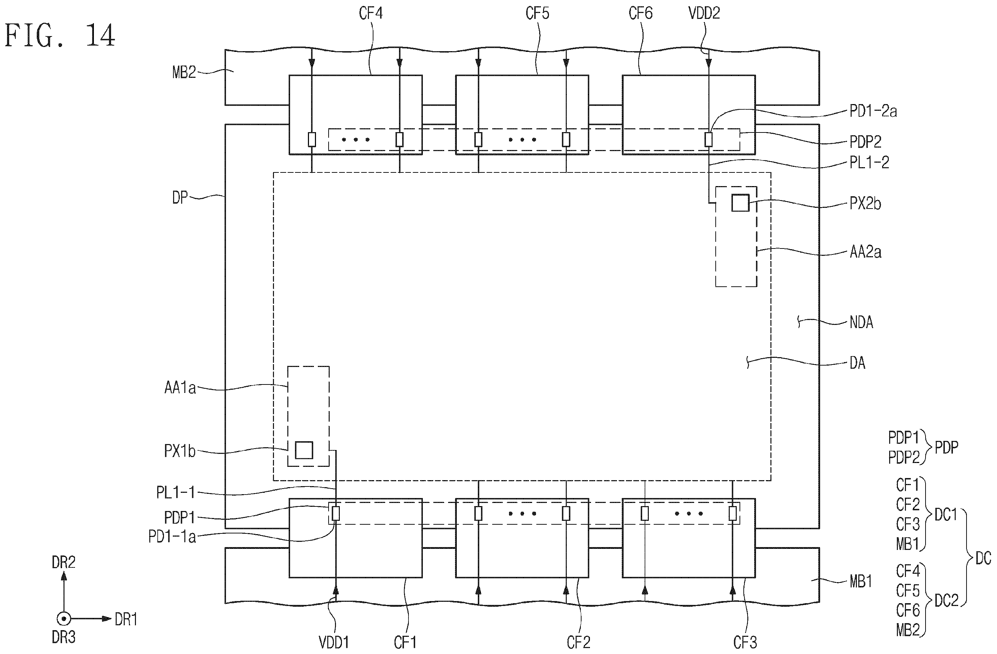

As the first vertical line and the second vertical line are disposed to overlap each other in a plan view, the first vertical line and the second vertical line may be disposed on different layers. For example, the first vertical line may be disposed on the fourth insulating layer 40 (see FIG. 8), and the second vertical line may be disposed on the third insulating layer 30 (see FIG. 8). FIGS. 13 and 14 are each a schematic plan view of a display panel and a driving circuit part according to an embodiment of the disclosure. Hereinafter, embodiments will be described by denoting the same/similar components as/to those described above as the same/similar reference numbers or symbols and avoiding the content about the same/similar components, and mainly in terms of differences.

Referring to FIG. 13, a display area DA may include multiple areas. For example, the display area DA may include a first area AA1 and a second area AA2. Although the display area DA including the first area AA1 and the second area AA2 is illustrated as an example, embodiments of the disclosure are not limited thereto. For example, the display area DA may further include a third area spaced apart from the first area AA1 and the second area AA2. Respective sizes of the first area AA1 and the second area AA2 may be different, and are not limited to thereto.

Pixels PXa may include first pixels PX1a and second pixels PX2a. The first pixels PX1a may be disposed in the first area AA1, and the second pixels PX2a may be disposed in the second area AA2. The first and second pixels PX1a and PX2a may have substantially the same configuration. The number of the first pixels PX1a and the number of the second pixels PX2a may be changed according to the sizes of the first area AA1 and the second area AA2.

A first power line PL1 may include a (1-1)-th power line PL1-1 and a (1-2)-th power line PL1-2. The (1-1)-th power line PL1-1 may be electrically connected to the first pixels PX1a disposed in the first area AA1, and the (1-2)-th power line PL1-2 may be electrically connected to the second pixels PX2a disposed in the second area AA2. For example, the (1-1)-th power line PL1-1 may be electrically connected to the first pixels PX1a and supply a first voltage VDD1 received from a (1-1)-th pad PD1-1 to the first pixels PX1a in common, and the (1-2)-th power line PL1-2 may be electrically connected to the second pixels PX2a and supply a second voltage VDD2 received from a (1-2)-th pad PD1-2 to the second pixels PX2a in common.

The (1-1)-th power line PL1-1 and the (1-2)-th power line PL1-2 may overlap the display area DA. The (1-1)-th power line PL1-1 and the (1-2)-th power line PL1-2 may extend in the second direction DR2. Although FIG. 13 illustrates the first power line PL1 including two power lines that are the (1-1)-th power line PL1-1 and the (1-2)-th power line PL1-2, embodiments of the disclosure are not limited, and the first power line PL1 may further include a third power line electrically connected to third pixels disposed in the third area of the display area DA.

The first area AA1 and the second area AA2 of the display area DA may display images with different luminance levels and thus, the display panel DP with improved display quality may be provided. Only a voltage level of the first voltage VDD1 may be adjusted so as to increase the luminance of the first area AA1, or only a voltage level of the second voltage VDD2 may be adjusted so as to increase the luminance of the second area AA2. Thus, the pixels PX1a and PX2a may be provided to be fitted to have voltage levels required for the pixels PX1a and PX2a, thereby reducing power consumption.

Referring to FIG. 14, a driving circuit part DC may include a first driving circuit part DC1 and a second driving circuit part DC2 which are spaced apart from each other in the second direction DR2. The first driving circuit part DC1 may be disposed at a lower side of a display panel DP, and the second driving circuit part DC2 may be disposed at an upper side of the display panel DP. The first driving circuit part DC1 may include a first main circuit board MB1 and flexible films CF1, CF2 and CF3. The second driving circuit part DC2 may include a second main circuit board MB2 and flexible films CF4, CF5 and CF6.

A pad portion PDP may include a first pad portion PDP1 disposed at the lower side of the display panel DP, and a second pad portion PDP2 disposed at the upper side of the display panel DP. The first pad portion PDP1 and the second pad portion PDP2 may be disposed in a non-display area NDA. The flexible films CF1, CF2 and CF3 may be electrically connected to the first pad portion PDP1, and the flexible films CF4, CF5 and CF6 may be electrically connected to the second pad portion PDP2.

The first pad portion PDP1 may include (1-1)-th pads PD1-1a which receive a first voltage VDD1, and the second pad portion PDP2 may include (1-2)-th pads PD1-2a which receive a second voltage VDD2. The (1-1)-th pads PD1-1a may provide the first voltage VDD1 to first pixels PX1b disposed in a first area AA1a, and the (1-2)-th pads PD1-2a may provide the second voltage VDD2 to second pixels PX2b disposed in a second area AA2a.

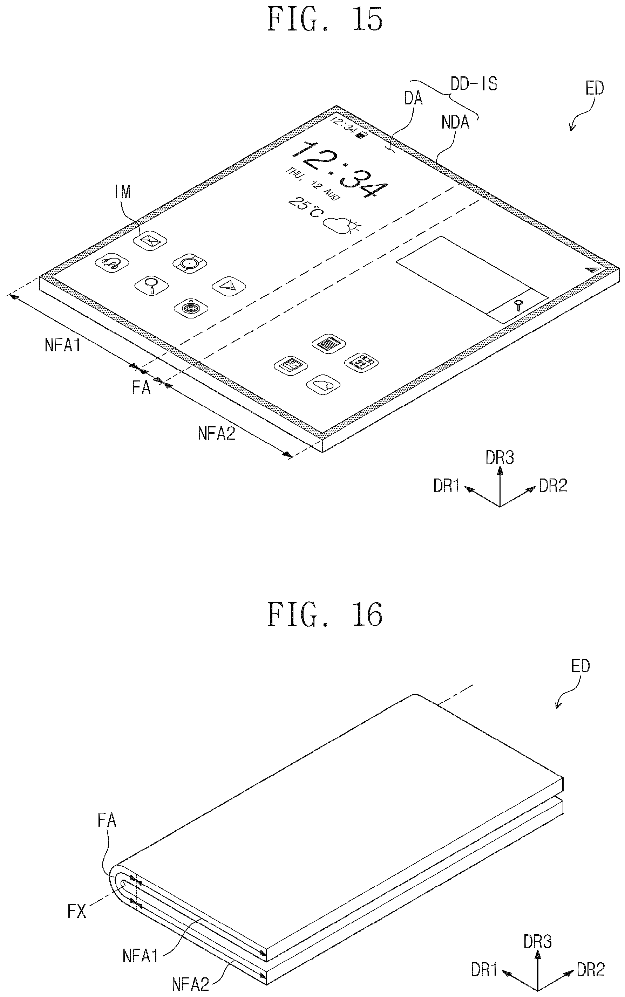

FIG. 15 is a schematic perspective view of an electronic device according to an embodiment of the disclosure. FIG. 16 is a schematic view illustrating a folded state of the electronic device illustrated in FIG. 15.

Referring to FIG. 15, an electronic device ED according to an embodiment of the disclosure may have a rectangular shape having short sides extending in a first direction DR1 and long sides extending in a second direction DR2 intersecting the first direction DR1. However, embodiments of the disclosure are not limited thereto, and the electronic device ED may have various shapes such as a circular shape and a polygonal shape. The electronic device ED may be flexible.

The electronic device ED may include a folding area FA and multiple non-folding areas NFA1 and NFA2. The non-folding areas NFA1 and NFA2 may include the first non-folding area NFA1 and the second non-folding area NFA2. The folding area FA may be disposed between the first non-folding area NFA1 and the second non-folding area NFA2. The folding area FA, the first non-folding area NFA1, and the second non-folding area NFA2 may be arranged in the first direction DR1.

Illustratively, one folding area FA and two non-folding areas NFA1 and NFA2 are illustrated, but the numbers of folding areas FA and the non-folding areas NFA1 and NFA2 are not limited thereto. For example, the electronic device ED may include more than two non-folding areas and multiple folding areas arranged between the non-folding areas.

An upper surface of the electronic device ED may be defined as a display surface DD-IS, and the display surface DD-IS may have the plane defined by the first direction DR1 and the second direction DR2. Images IM generated by the electronic device ED may be provided to a user through the display surface DD-IS.

The display surface DD-IS may include a display area DA and a non-display area NDA around the display area DA. The display area DA displays an image, and the non-display area NDA does not display the image. The non-display area NDA may surround the display area DA and may define an edge of the electronic device ED printed in a predetermined color.

Referring to FIG. 16, the electronic device ED may be a foldable electronic device ED that is folded or unfolded. For example, the folding area FA may be bent with respect to a folding axis FX parallel to the second direction DR2, and thus the electronic device ED may be folded. The folding axis FX may be defined as a long axis parallel to the long sides of the electronic device ED. In case that the electronic device ED is folded, the first non-folding area NFA1 and the second non-folding area NFA2 may face each other, and the electronic device ED may be in-folded so that the display surface DD-IS is not exposed to the outside. However, embodiments of the disclosure are not limited thereto. For example, although not illustrated, the electronic device ED may be out-folded so that the display surface DD-IS is exposed to the outside about the folding axis FX. Further, although not illustrated, the electronic device ED may be in-folded and out-folded at the same time.

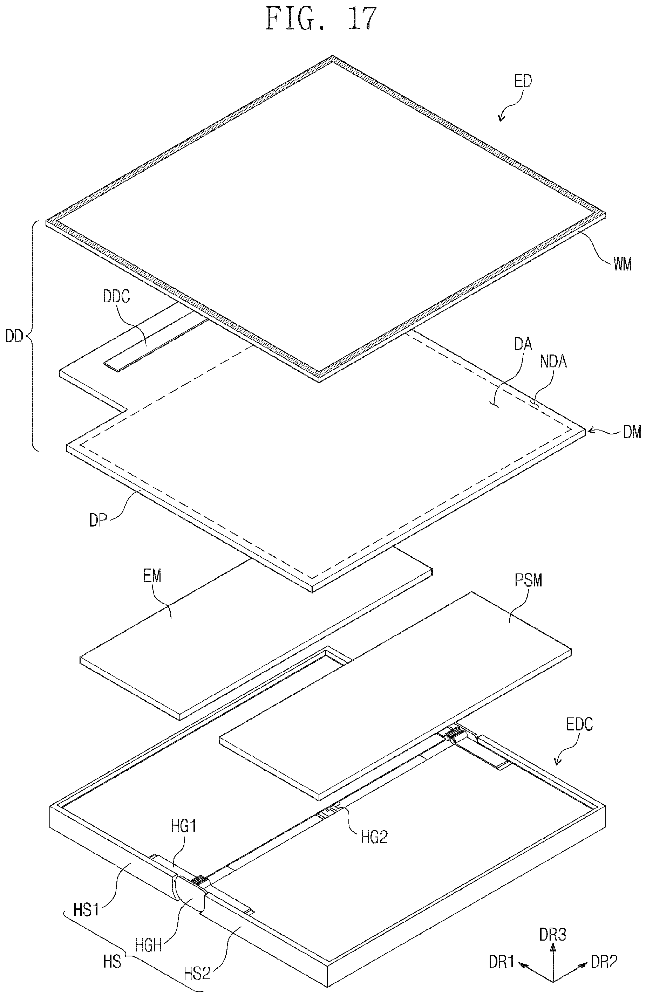

FIG. 17 is an exploded schematic perspective view of the electronic device illustrated in FIG. 15.

Referring to FIG. 17, the electronic device ED may include a display device DD, an electronic module EM, a power supply module PSM, and a hinge module EDC. Although not illustrated, the electronic device ED may further include a mechanical structure (e.g., a hinge) for controlling a folding operation of the display device DD.

The display device DD may generate an image and sense an external input. The display device DD may include a window module WM and a display module DM. The window module WM may provide a front surface of the electronic device ED. The window module WM may be disposed on the display module DM to protect the display module DM. The window module WM may transmit a light generated by the display module DM and provide the light to the user.

The display module DM may include a display panel DP. FIG. 17 illustrates only the display panel DP among laminated structures of the display module DM, but substantially, the display module DM may further include multiple components arranged on an upper side and a lower side of the display panel DP. The display panel DP may include a display area DA and a non-display area NDA corresponding to the display area DA and the non-display area NDA of FIG. 15 of the electronic device ED.

The display module DM may include a data driver DDC disposed on the non-display area NDA of the display panel DP. The data driver DDC may be manufactured (or directly manufactured) in the form of a circuit chip and mounted on the non-display area NDA. However, embodiments of the disclosure are not limited thereto, and the data driver DDC may be mounted on a flexible circuit board electrically connected to the display panel DP.

The electronic module EM and the power supply module PSM may be arranged inside the hinge module EDC. Illustratively, FIG. 15 illustrates a state in which the electronic module EM and the power supply module PSM are exposed to the outside from the hinge module EDC. Although not illustrated, the electronic module EM and the power supply module PSM may be electrically connected to each other through a separate flexible circuit board. The electronic module EM may control an operation of the display device DD. The power supply module PSM may supply power to the electronic module EM.

The hinge module EDC may accommodate the display device DD, the electronic module EM, and the power supply module PSM. The hinge module EDC may include two first and second housings HS1 and HS2 for folding the display device DD. The first and second housings HS1 and HS2 may extend in the second direction DR2 and may be arranged in the first direction DR1.

The hinge module EDC may include a housing assembly HS. The housing assembly HS may include a first housing HS1 and a second housing HS2 spaced apart from each other in the first direction DR1 and a hinge housing HGH disposed between the first housing HS1 and the second housing HS2. The hinge module EDC may further include hinges HG1 and HG2 for connecting the first and second housings HS1 and HS2, multiple main plates, and multiple moving plates.

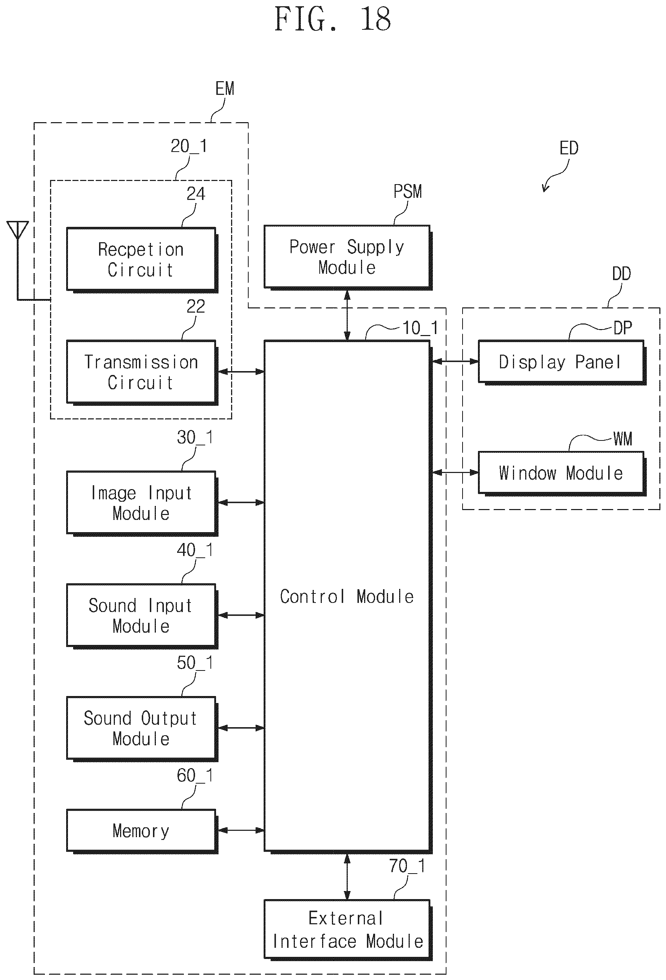

FIG. 18 is a schematic block diagram of the electronic device illustrated in FIG. 17.

Referring to FIG. 18, the electronic device ED may include the electronic module EM, the power supply module PSM, and the display device DD. The electronic module EM may include a control module 10_1, a wireless communication module 20_1, an image input module 30_1, a sound input module 40_1, a sound output module 50_1, a memory 60_1, an external interface module 70_1, and the like. The modules may be mounted on a circuit board or may be electrically connected through a flexible circuit board. The electronic module EM may be electrically connected to the power supply module PSM.

The control module 10_1 may control an overall operation of the electronic device ED. For example, the control module 10_1 may activate or deactivate the display device DD in accordance with a user input. The control module 10_1 may control the image input module 30_1, the sound input module 40_1, the sound output module 50_1, and the like in accordance with the user input. The control module 10_1 may include at least one microprocessor.

The wireless communication module 20_1 may transmit/receive a wireless signal to/from another terminal using a Bluetooth line or a Wi-Fi line. The wireless communication module 20_1 may transmit/receive a voice signal using a general communication line. The wireless communication module 20_1 may include a transmission circuit 22 for modulating and transmitting a signal to be transmitted, and a reception circuit 24 for demodulating a received signal.

The image input module 30_1 may process an image signal and convert the image signal into image data that may be displayed on the display device DD. The sound input module 40_1 may receive an external sound signal through a microphone in a recording mode or a voice recognition mode and convert the received external sound signal into electrical voice data. The sound output module 50_1 may convert sound data received from the wireless communication module 20_1 or sound data stored in the memory 60_1 and output the converted sound data to the outside.

The external interface module 70_1 may serve as an interface electrically connected to an external charger, a wired/wireless data port, and a card socket (e.g., a memory card, a subscriber identity module (SIM)/user interface model (UIM) card).

The power supply module PSM may supply power required for an overall operation of the electronic device ED. The power supply module PSM may include a general battery device.

The first voltage applied to the first pixel disposed in the display area and the second voltage applied to the second pixel disposed in the display area are different from each other. As the result, the pixels disposed in the different areas of the display area may emit the light having the different luminance levels, and thus the display panel with the improved display quality may be provided.

The first voltage may be applied (or directly applied) to the first pixel through the (1-1)-th power line, and the second voltage may be applied (or directly applied) to the second pixel through the (1-2)-th power line, thereby preventing the voltage drop (IR-DROP) phenomenon which occurs as the current path becomes long, and preventing the display quality of the display panel from deteriorating.

The electronic device ED may include a computing system providing an image display function, such as a smart watch, a mobile phone, a smart phone, a portable computer, a tablet personal computer (PC), a watch phone, an automotive display, smart glasses, a portable multimedia player (PMP), a navigation device, and an ultra mobile personal computer (UMPC). The display system 1000 may include at least one of a head mounted display (HMD) device, a virtual reality (VR) device, a mixed reality (MR) device, and an augmented reality (AR) device.

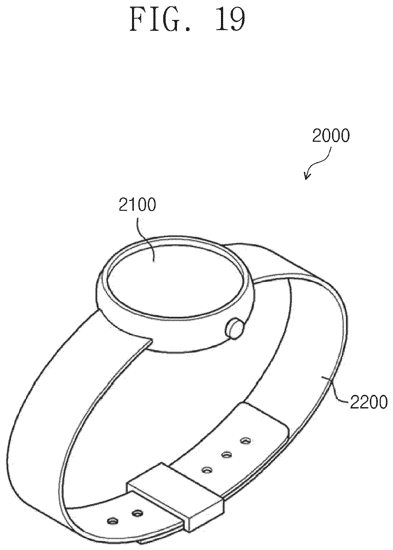

Referring to FIG. 19, the electronic device ED of FIG. 18 may be applied to a smart watch 2000 including a display unit 2100 and a strap unit 2200.

The smart watch 2000 may be a wearable electronic device. For example, the smart watch 2000 may have a structure in which the strap unit 2200 is mounted on a user's wrist. Here, the electronic device ED may be applied to the display unit 2100, and image data including time information may be provided to a user.

As discussed, embodiments can provide a display device comprising: a base layer including a display area in which a plurality of pixels are disposed, and a non-display area disposed around the display area; a conductive layer overlapping a least a portion of the plurality of pixels in a plan view; a first power line electrically connected to the plurality of pixels; and a second power line electrically connected to the plurality of pixels; wherein the conductive layer includes: a first conductive layer overlapping a first pixel of the plurality of pixels in a plan view; and a second conductive layer overlapping a second pixel of the plurality of pixels in a plan view and disposed apart from the first conductive layer, and wherein the first power line includes: a (1-1)-th power line electrically connected to the first pixel through the first conductive layer; and a (1-2)-th power line electrically connected to the second pixel through the second conductive layer.

The (1-1)-th power line may be connected to a first power supply arranged to supply a first voltage. The (1-2)-th power line may be connected to a second power supply arranged to supply a second voltage. The second voltage may be different to the first voltage.

The (1-1)-th power line and the (1-2)-th power line may extend in a same direction.

The (1-1)-th power line PL1-1 and the (1-2)-th power line PL1-2 may be arranged so as to not overlap each other in a plan view.

The display area may be divided into a plurality of areas, and a driving element layer may be disposed on the base layer and including a pixel driver. A plurality of light emitting elements may be disposed on the driving element layer, and each including a first electrode, an intermediate layer disposed on the first electrode, and a second electrode disposed on the intermediate layer.

A first power line may be electrically connected to the first electrode included in each of the light emitting elements, and a second power line may be electrically connected to the second electrode included in each of the light emitting elements.

The first electrode may include the (1-1)-th electrode disposed in a first area of the plurality of areas to receive a first voltage through a (1-1)-th power line of the first power line; and the (1-2)-th electrode may be disposed in a second area of the plurality of areas to receive a second voltage different from the first voltage through a (1-2)-th power line of the first power line.

Embodiments can provide a display device comprising: a base layer including a display area divided into a plurality of areas, and a non-display area disposed around the display area; a driving element layer disposed on the base layer and including a pixel driver; a plurality of light emitting elements disposed on the driving element layer, and each including a first electrode, an intermediate layer disposed on the first electrode, and a second electrode disposed on the intermediate layer; a first power line electrically connected to the first electrode included in each of the light emitting elements; and a second power line electrically connected to the second electrode included in each of the light emitting elements, wherein the first electrode includes: a (1-1)-th electrode disposed in a first area of the plurality of areas to receive a first voltage through a (1-1)-th power line of the first power line; and a (1-2)-th electrode disposed in a second area of the plurality of areas to receive a second voltage different from the first voltage through a (1-2)-th power line of the first power line.

Embodiments can provide an electronic device comprising: a display device; an electronic module overlapping the display device; and a housing accommodating the display device, wherein the display device including: a base layer including a display area in which a plurality of pixels are disposed, and a non-display area disposed around the display area; a conductive layer overlapping a least a portion of the plurality of pixels in a plan view; a first power line electrically connected to the plurality of pixels; and a second power line electrically connected to the plurality of pixels, the conductive layer includes: a first conductive layer overlapping a first pixel of the plurality of pixels in a plan view; and a second conductive layer overlapping a second pixel of the plurality of pixels in a plan view and disposed apart from the first conductive layer, and the first power line includes: a (1-1)-th power line electrically connected to the first pixel through the first conductive layer; and a (1-2)-th power line electrically connected to the second pixel through the second conductive layer.

Although the embodiments of the disclosure have been described, it is understood that the disclosure should not be limited to these embodiments but various changes and modifications can be made by one ordinary skilled in the art within the scope of the disclosure as hereinafter claimed.

Therefore, the technical scope of the disclosure is not limited to the contents described in the detailed description of the specification, but should be determined by the claims.

## Claims

1. A display device comprising:
a base layer including a display area in which a plurality of pixels are disposed, and a non-display area disposed around the display area;
a conductive layer overlapping a least a portion of the plurality of pixels in a plan view;
a first power line electrically connected to the plurality of pixels; and
a second power line electrically connected to the plurality of pixels;
wherein the conductive layer includes:
a first conductive layer overlapping a first pixel of the plurality of pixels in a plan view; and
a second conductive layer overlapping a second pixel of the plurality of pixels in a plan view and disposed apart from the first conductive layer, and
wherein the first power line includes:
a (1-1)-th power line electrically connected to the first pixel through the first conductive layer; and
a (1-2)-th power line electrically connected to the second pixel through the second conductive layer.

2. The display device of claim 1, wherein
each of the plurality of pixels includes:
a pixel driver disposed on the base layer and including a transistor; and
a light emitting element disposed on the transistor, and including a first electrode, an intermediate layer disposed on the first electrode, and a second electrode disposed on the intermediate layer,
wherein the first power line is electrically connected to the first electrode, and the second power line is electrically connected to the transistor.

3. The display device of claim 2, wherein the first electrode includes:
a (1-1)-th electrode electrically connected to the (1-1)-th power line; and
a (1-2)-th electrode electrically connected to the (1-2)-th power line, and
the (1-1)-th electrode and the (1-2)-th electrode are electrically disconnected from each other.

4. The display device of claim 3, wherein
the (1-1)-th electrode and the first conductive layer are disposed on different layers, and electrically connected to the first conductive layer through a first contact hole, and
the (1-2)-th electrode and the second conductive layer are disposed on different layers, and electrically connected to the second conductive layer through a second contact hole.

5. The display device of claim 4, wherein
the (1-1)-th electrode includes a plurality of first sub-electrodes, and
the first sub-electrodes are disposed apart from each other in a plan view;
optionally wherein the first conductive layer overlaps a portion of each of the first sub-electrodes in a plan view.

6. The display device of claim 5, wherein
the first conductive layer includes a plurality of first sub-conductive layers, and
the first sub-conductive layers have shapes corresponding to shapes of the first sub-electrodes, respectively;
optionally wherein the first conductive layer further includes a connection pattern which connects the first sub-conductive layers together.

7. The display device of any one of claims 2 to 8, wherein
the (1-1)-th power line includes:
a horizontal line extending in a first direction; and
a vertical line extending in a second direction intersecting the first direction,
and
wherein the horizontal line and the first conductive layer are disposed on a same layer, and the horizontal line extends from the first conductive layer;
optionally wherein the vertical line extends from the horizontal line and does not overlap the first electrode in a plan view;
optionally wherein the vertical line and the horizontal line are disposed on different layers, and the vertical line is electrically connected to the horizontal line through a contact hole.

8. The display device of claim 3 or any claim when dependent on claim 3, wherein
a surface area of the first conductive layer is greater than a surface area of the (1-1)-th electrode,
a surface area of the second conductive layer is greater than a surface area of the (1-2)-th electrode and a planar shape of the first conductive layer and a planar shape of the second conductive layer are different.

9. The display device of any one of claims 1 to 8, wherein
the (1-1)-th power line and the first conductive layer are disposed on different layers,
the (1-1)-th power line is electrically connected to the first conductive layer through a contact hole, and
the (1-1)-th power line overlaps the pixels.

10. The display device of any one of claims 1 to 8, further comprising:
a pad portion disposed in the non-display area,
wherein the pad portion includes:
a first voltage pad electrically connected to the first power line; and
a second voltage pad electrically connected to the second power line.

11. The display device of claim 10, wherein the first voltage pad includes:
a (1-1)-th voltage pad electrically connected to the (1-1)-th power line; and
a (1-2)-th voltage pad electrically connected to the (1-2)-th power line.

12. The display device of claim 10 or 11, wherein the pad portion includes a first pad portion and a second pad portion which are spaced apart from each other with respect to the display area therebetween.

13. The display device of claim 1, wherein
each of the plurality of pixels includes:
a pixel driver disposed on the base layer and including a transistor; and
a light emitting element disposed on the transistor, and including a first electrode, an intermediate layer disposed on the first electrode, and a second electrode disposed on the intermediate layer, and
the display device further includes a connection electrode arranged to electrically connect the transistor to the second electrode together;
optionally further comprising: a pixel defining film in which an opening which exposes at least a portion of the first electrode is defined; and a separator disposed on the pixel defining film, wherein, in a contact area adjacent to the separator, a bottom surface of the second electrode is in contact with a top surface of the connection electrode, and the connection electrode has a ring shape which surrounds the opening.

14. A display device comprising:
a base layer including a display area divided into a plurality of areas, and a non-display area disposed around the display area;
a driving element layer disposed on the base layer and including a pixel driver;
a plurality of light emitting elements disposed on the driving element layer, and each including a first electrode, an intermediate layer disposed on the first electrode, and a second electrode disposed on the intermediate layer;
a first power line electrically connected to the first electrode included in each of the light emitting elements; and
a second power line electrically connected to the second electrode included in each of the light emitting elements,
wherein the first electrode includes:
a (1-1)-th electrode disposed in a first area of the plurality of areas to receive a first voltage through a (1-1)-th power line of the first power line; and
a (1-2)-th electrode disposed in a second area of the plurality of areas to receive a second voltage different from the first voltage through a (1-2)-th power line of the first power line.

15. An electronic device comprising:
a display device;
an electronic module overlapping the display device; and
a housing accommodating the display device,
wherein the display device is according to any one of claims 1 to 14.
